# EUROPEAN PATENT APPLICATION

(11) **EP 4 761 540 A1**
(43) Date of publication of application: **17.06.2026**
(21) Application number: 23962792.0
(22) Date of filing: 29.12.2023
(51) Int. Cl.: H10K 59/122, H10K 59/12, H10K 71/00

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: XU, Guanghua, Beijing 100176 (CN); HE, Fan, Beijing 100176 (CN); ZHOU, Hongjun, Beijing 100176 (CN); WANG, Hongli, Beijing 100176 (CN)
(74) Representative: Brötz, Helmut
(86) International application number: PCT/CN2023/143287
(87) International publication number: WO 2025/138117

(57) **Abstract**

A display substrate and a manufacturing method therefor, and a display device. In the display substrate, a pixel defining layer comprises a first pixel aperture and a first isolation aperture, the first pixel aperture is located on the side of a first electrode of a first light-emitting element distant from a base substrate and exposes at least part of the first electrode, and the first isolation aperture is located on the periphery of the first pixel aperture; the pixel defining layer comprises a first pixel defining portion located between the first pixel aperture and the first isolation aperture and a second pixel defining portion located on the side of the first isolation aperture distant from the first pixel aperture; and the first pixel defining portion comprises a first main body portion and a first compensation portion which are connected, the first compensation portion is located on the side of the first main body portion close to the first isolation aperture, and the first compensation portion is provided with a first protruding contour protruding from the top of the first main body portion in a direction away from the base substrate, so that the maximum height of the first compensation portion is greater than the maximum height of the first main body portion. Therefore, the display substrate can avoid dark spots and color casts.

## Description

### TECHNICAL FIELD

Embodiments of the present disclosure relate to a display substrate and manufacturing method thereof, and a display device.

### BACKGROUND

Organic light emitting diode display devices (OLED) have become a research hotspot and technology development direction for major manufacturers due to their advantages such as wide color gamut, high contrast, thin and light design, self-luminescence, and wide viewing angle. At present, the organic light emitting diode display devices (OLED) have been widely used in various electronic products, from small electronic products such as smart bracelets, smart watches, smart phones and tablet computers, to large electronic products such as laptops, desktop computers and televisions. Therefore, the demand for active matrix organic light emitting diode display devices is also growing day by day.

With the continuous development of display technology, people's pursuit of display quality is also increasing. In order to further reduce power consumption and achieve high brightness, a single-layer light emitting layer in a light emitting element in an OLED can be replaced with two light emitting layers, and a charge generation layer (CGL) is added between the two light emitting layers to realize a double-layer light emitting (Tandem EL) design. Since the display device using a tandem EL design has two light emitting layers, its light emitting brightness is approximately twice that of a single light emitting layer. In this way, the display device adopting the double-layer light emitting design has the advantages of long life, low power consumption and high brightness.

### SUMMARY

Embodiments of the present disclosure further provide a display substrate, a manufacturing method thereof, and a display device. The display substrate reduces or even eliminates adverse effects of an exposure diffraction effect on the first pixel definition part by adding a first compensation part at the edge of the first pixel definition part next to the first isolation opening, thus the first pixel definition part next to the first isolation opening is prevented from being excessively thinned, thereby avoiding dark spots and color shift problems.

At least one embodiment of the present disclosure provides a display substrate, which includes: a base substrate; a plurality of light emitting elements, located on the base substrate; and a pixel definition layer, each of the plurality of light emitting elements includes a first electrode, a light emitting function layer and a second electrode, the plurality of light emitting elements include a first light emitting element, the pixel definition layer includes a first pixel opening and a first isolation opening, the first pixel opening is located at a side of the first electrode of the first light emitting element away from the base substrate, and exposes at least a part of the first electrode, the first isolation opening is located at a periphery of the first pixel opening, the pixel definition layer includes a first pixel definition part located between the first pixel opening and the first isolation opening, and a second pixel definition part located on a side of the first isolation opening away from the first pixel opening, the first pixel definition part includes a first main body part and a first compensation part that are connected with each other, the first compensation part is located on a side of the first main body part close to the first isolation opening, the first compensation part has a first protruding profile protruding from a top of the first main body part toward a direction away from the base substrate, to make that a maximum height of the first compensation part is greater than a maximum height of the first main body part.

For example, in the display substrate provided by an embodiment of the present disclosure, one end of the first protruding profile is located at the top of the first main body part, other end of the first protruding profile is located at an edge of the first isolation opening.

For example, in the display substrate provided by an embodiment of the present disclosure, the first protruding profile intersects with an upper surface of the first main body part away from the base substrate at an inflection point, an angle between a tangent line passing through the inflection point and tangent to the first protruding profile and a tangent line passing through the inflection point and tangent to the upper surface is less than 180 degrees.

For example, in the display substrate provided by an embodiment of the present disclosure, an edge profile of the first pixel definition part close to the first isolation opening has a first slope angle, an edge profile of the second pixel definition part close to the first isolation opening has a second slope angle, and a difference between the first slope angle and the second slope angle ranges from 0 to 40 degrees.

For example, in the display substrate provided by an embodiment of the present disclosure, the first slope angle is greater than the second slope angle, and the difference between the first slope angle and the second slope angle ranges from 20 to 40 degrees.

For example, in the display substrate provided by an embodiment of the present disclosure, an edge profile of the first pixel definition part close to the first pixel opening has a third slope angle, and a difference between the third slope angle and the first slope angle ranges from 20 to 40 degrees.

For example, in the display substrate provided by an embodiment of the present disclosure, a difference between the third slope angle and the second slope angle is less than 5 degrees.

For example, in the display substrate provided by an embodiment of the present disclosure, a maximum height of the first main body part is the same as a maximum height of the second pixel definition part, and a maximum height of the first compensation part is greater than the maximum height of the first main body part.

For example, in the display substrate provided by an embodiment of the present disclosure, the first protruding profile has a fourth slope angle on a side close to the first main body part, and the fourth slope angle has a value range of 0 to 20 degrees.

For example, in the display substrate provided by an embodiment of the present disclosure, a direction from the first pixel opening to the first isolation opening is a first direction, a ratio of a width of the first compensation part in the first direction to a width of the first main body part in the first direction is in a range of 0 to 0.3.

For example, the display substrate provided by an embodiment of the present disclosure further including: an isolation function layer, located between the base substrate and the plurality of light emitting elements in a direction perpendicular to the base substrate, the isolation function layer includes a first isolation groove, an orthographic projection of the first isolation opening on the base substrate covers an edge of the first isolation groove close to the first pixel opening.

For example, in the display substrate provided by an embodiment of the present disclosure, the light emitting function layer includes a charge generation layer, and the charge generation layer is disconnected at an edge of the first isolation groove close to the first pixel opening.

For example, in the display substrate provided by an embodiment of the present disclosure, the light emitting function layer further includes a first light emitting layer and a second light emitting layer located on two sides of the charge generation layer in a direction perpendicular to the base substrate respectively.

For example, in the display substrate provided by an embodiment of the present disclosure, the plurality of light emitting elements include a second light emitting element, the pixel definition layer further includes a second pixel opening, located on a side of the first electrode of the second light emitting element away from the base substrate, and exposing at least a part of the first electrode, the second pixel opening is located on a side of the first isolation opening away from the first pixel opening, and the second pixel definition part is located between the first isolation opening and the second pixel opening.

For example, in the display substrate provided by an embodiment of the present disclosure, a size of the second pixel definition part in a first direction is greater than a size of the first pixel definition part in the first direction.

For example, in the display substrate provided by an embodiment of the present disclosure, the second pixel definition part includes a second main body part and a second compensation part that are connected with each other, the second compensation part is located on a side of the second main body part close to the first isolation opening, the second compensation part has a second protruding profile that protrudes from a top of the second main body part toward a direction away from the base substrate, to make that a maximum height of the second compensation part is greater than a maximum height of the second main body part.

For example, in the display substrate provided by an embodiment of the present disclosure, the first compensation part and the second compensation part are connected at two opposite edges of the first isolation opening in a second direction, to surround the first isolation opening, the second direction is perpendicular to a direction from the first pixel opening to the first isolation opening.

For example, in the display substrate provided by an embodiment of the present disclosure, a size of the second pixel definition part in a first direction is equal to a size of the first pixel definition part in the first direction.

For example, in the display substrate provided by an embodiment of the present disclosure, the plurality of light emitting elements include a third light emitting element, the pixel definition layer further includes a third pixel opening and a second isolation opening, the third pixel opening is located at a side of the first electrode of the third light emitting element away from the base substrate and exposes at least a part of the first electrode, and the second isolation opening is located between the first pixel opening and the third pixel opening, the pixel definition layer includes a third pixel definition part located between the first pixel opening and the second isolation opening and a fourth pixel definition part located between the second isolation opening and the third pixel opening, and the third pixel definition part includes a third main body part and a third compensation part that are connected to each other, the third compensation part is located on a side of the third main body part close to the second isolation opening, the third compensation part has a third protruding profile protruding from a top of the third main body part toward a direction away from the base substrate, to make that a maximum height of the third compensation part is greater than a maximum height of the third main body part.

For example, the display substrate provided by an embodiment of the present disclosure further includes: an isolation function layer, located between the base substrate and the plurality of light emitting elements in a direction perpendicular to the base substrate, the isolation function layer includes a second isolation groove, and an orthographic projection of the second isolation opening on the base substrate covers an edge of the second isolation groove close to the first pixel opening.

For example, in the display substrate provided by an embodiment of the present disclosure, a shape of an orthographic projection of the first isolation opening on the base substrate includes at least one of a strip shape and an L shape.

For example, in the display substrate provided by an embodiment of the present disclosure, the first compensation part is reused as a spacer.

For example, in the display substrate provided by an embodiment of the present disclosure, a maximum height of the spacer in a direction perpendicular to the base substrate is in a range of 0.9 microns to 1.3 microns.

For example, in the display substrate provided by an embodiment of the present disclosure, a difference between a maximum height of the spacer and the maximum height of the first main body part is in a range of 0.1 microns to 0.5 microns.

At least one embodiment of the present disclosure further provides a display substrate, which includes: a base substrate; a plurality of light emitting elements, located on the base substrate; and a pixel definition layer, each of the plurality of light emitting elements includes a first electrode, a light emitting function layer and a second electrode, the plurality of light emitting elements include a first light emitting element, the pixel definition layer includes a first pixel opening and a first isolation opening, the first pixel opening is located at a side of a first electrode of the first light emitting element away from the base substrate and exposes at least a part of the first electrode, and the first isolation opening is located at a periphery of the first pixel opening, the pixel definition layer includes a first pixel definition part located between the first pixel opening and the first isolation opening, and a second pixel definition part located on a side of the first isolation opening away from the first pixel opening, and an edge profile of the first pixel definition part close to the first isolation opening has a first slope angle, an edge profile of the second pixel definition part close to the first isolation opening has a second slope angle, and the first slope angle and the second slope angle are different from each other.

For example, in the display substrate provided by an embodiment of the present disclosure, the first slope angle is greater than the second slope angle.

At least one embodiment of the present disclosure further provides a display device, which includes the abovementioned display substrate.

At least one embodiment of the present disclosure further provides a manufacturing method of a display substrate, which includes: forming a first electrode on a base substrate; forming a pixel definition layer on a side of the first electrode away from the base substrate; forming a light emitting function layer on a side of the pixel definition layer away from the first electrode; and forming a second electrode on a side of the light emitting function layer away from the base substrate, the display substrate includes a plurality of light emitting elements, each of the plurality of the light emitting elements includes the first electrode, the light emitting function layer and the second electrode, the plurality of light emitting elements include a first light emitting element, the pixel definition layer includes a first pixel opening and a first isolation opening, the first pixel opening is located at a side of the first electrode of the first light emitting element away from the base substrate and exposes at least a part of the first electrode, and the first isolation opening is located at a periphery of the first pixel opening, the pixel definition layer includes a first pixel definition part located between the first pixel opening and the first isolation opening, and a second pixel definition part located on a side of the first isolation opening away from the first pixel opening, the first pixel definition part includes a first main body part and a first compensation part that are connected with each other, the first compensation part is located on a side of the first main body part close to the first isolation opening, the first compensation part has a first protruding profile that protrudes from a top of the first main body part toward a direction away from the base substrate, to make that a maximum height of the first compensation part is greater than the maximum height of the first main body part.

For example, in the manufacturing method of a display substrate provided by an embodiment of the present disclosure, forming a pixel definition layer on a side of the first electrode away from the base substrate includes: forming a pixel definition material layer on a side of the first electrode away from the base substrate; and patterning a pixel definition material layer by using a half-tone mask to form the first pixel opening, the first isolation opening, the first pixel definition part and the second pixel definition part, a first main body part of the first pixel definition part corresponds to a part of a transparent part of the half-tone mask, and the first compensation part corresponds to a completely blocking part of the half-tone mask.

### BRIEF DESCRIPTION OF DRAWINGS

In order to more clearly explain the technical solution of the embodiments of the present disclosure, the accompanying drawings of the embodiments will be briefly introduced below. Obviously, the accompanying drawings in the following description only relate to some embodiments of the present disclosure, and are not limited to the present disclosure.
Fig. 1 is a cross-sectional schematic diagram of a display substrate provided by an embodiment of the present disclosure;
Fig. 2 is a focused ion beam scanning electron microscope diagram of a display substrate provided by an embodiment of the present disclosure;
Fig. 3A is a H-direction color shift test diagram of a display substrate provided by an embodiment of the present disclosure;
Fig. 3B is a V-direction color shift test diagram of a display substrate provided by an embodiment of the present disclosure;
Fig. 4 is a schematic diagram of a color shift test direction of a display substrate provided by an embodiment of the present disclosure;
Fig. 5 is a planar schematic diagram of a display substrate provided by an embodiment of the present disclosure;
Fig. 6 is a cross-sectional schematic diagram of a display substrate along the AB direction in Fig. 5 provided by an embodiment of the present disclosure;
Fig. 7 is a cross-sectional schematic diagram of another display substrate provided by an embodiment of the present disclosure along the AB direction in Fig. 5;
Fig. 8 is a planar schematic diagram of another display substrate provided by an embodiment of the present disclosure;
Fig. 9 is a cross-sectional schematic diagram of a display substrate along the CD direction in Fig. 8 provided by an embodiment of the present disclosure;
Fig. 10 is a cross-sectional schematic diagram of a display substrate along the direction EF in Fig. 8 provided by an embodiment of the present disclosure;
Fig. 11 is a planar schematic diagram of another display substrate provided by an embodiment of the present disclosure;
Fig. 12 is a cross-sectional schematic diagram of a display substrate along the GH direction in Fig. 11 provided by an embodiment of the present disclosure;
Fig. 13 is a planar schematic diagram of another display substrate provided by an embodiment of the present disclosure;
Fig. 14A to Fig. 14C are planar schematic diagrams of other display substrates provided by an embodiment of the present disclosure;
Fig. 15 is a schematic diagram of a display device provided by an embodiment of the present disclosure; and
Fig. 16 is a flow chart of a manufacturing method of a display substrate provided by an embodiment of the present disclosure.

### DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment (s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects.

Unless otherwise defined, the features such as "parallel", "vertical" and "identical" used in the embodiments of the present disclosure all comprise situations such as "parallel", "vertical" and "identical" in a strict sense, and situations such as "substantially parallel", " substantially vertical" and " substantially identical" that contain the cases of certain errors. For example, the above-mentioned term "substantially" means that the difference of the compared objects is within 10% or 5% of the average value of the compared objects. When the number of one component or element is not specified in the following of the embodiments of the present disclosure, it means that the component or element may be one or more, or may be understood as at least one. "At least one" means one or more, and "multiple/a plurality of" means at least two. The term "in a same layer" in the embodiments of the present disclosure refers to the relationship between multiple layers formed by the same material after the same one step (for example, one-step patterning process). The term "same layer" here does not always mean that the thickness of multiple layers is the same or the height of multiple layers in cross-sectional view is the same.

In an OLED display device with a double-layer light emitting design, since a charge generation layer is between two light emitting layers, it is necessary to add a pixel isolation structure between adjacent sub-pixels to isolate the charge generation layer. For example, the pixel isolation structure may be a pixel isolation groove, the charge generation layer can be broken at the pixel isolation groove, thus a crosstalk problem between adjacent sub-pixels is avoided. After adding the above-mentioned pixel isolation groove, in order to ensure that the charge generation layer is effectively isolated, it is necessary to remove the pixel definition layer above the pixel isolation groove, that is, an isolation opening exposing the pixel isolation groove is formed in the pixel definition layer. This is because, if the pixel definition layer is not removed, the pixel isolation groove will be filled.

In this regard, embodiments of the present disclosure provide a display substrate, manufacturing method thereof, and a display device. The display substrate comprises a base substrate, a plurality of light emitting elements and a pixel definition layer; the plurality of light emitting elements are located on the base substrate; each of the plurality of light emitting elements includes a first electrode, a light emitting function layer, and a second electrode; the plurality of light emitting elements include a first light emitting element; the pixel definition layer includes a first pixel opening and a first isolation opening, the first pixel opening is located at a side of a first electrode of the first light emitting element away from the base substrate and exposes at least a part of the first electrode; the first isolation opening is located at a periphery of the first pixel opening; the pixel definition layer includes a first pixel definition part located between the first pixel opening and the first isolation opening and a second pixel definition part located on a side of the first isolation opening away from the first pixel opening. In this way, the display substrate can realize a double-layer light emitting (Tandem EL) design, so that the display substrate has the advantages of long life, low power consumption, and high brightness. On the other hand, the display substrate also avoids crosstalk between adjacent light emitting elements.

Hereinafter, the display substrate, manufacturing method thereof and the display device provided by the embodiments of the present disclosure are described in detail with reference to the accompanying drawings.

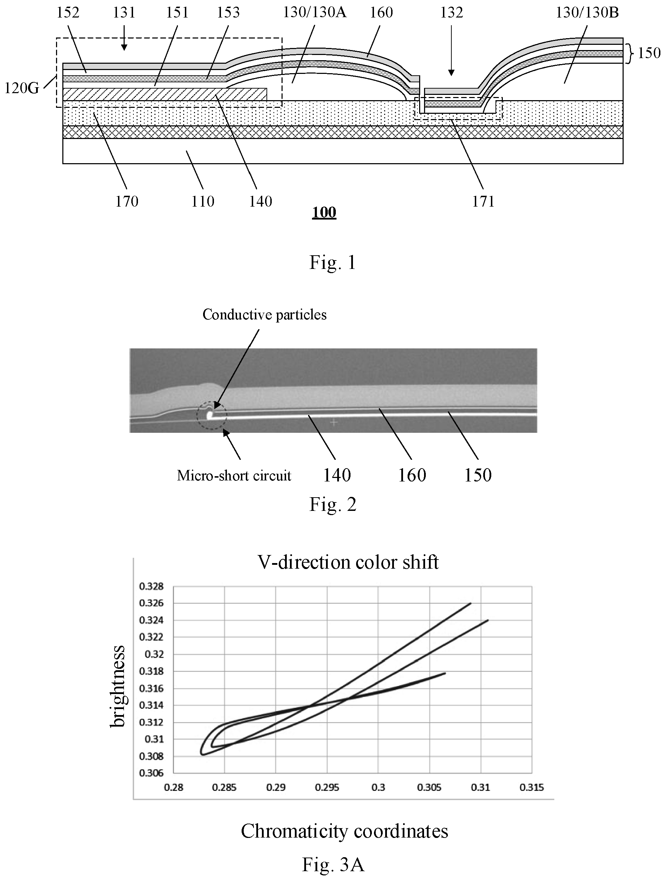

Fig. 1 is a cross-sectional schematic diagram of a display substrate provided by an embodiment of the present disclosure. As illustrated by Fig. 1, the display substrate 100 includes a base substrate 110, a plurality of light emitting elements, and a pixel definition layer 130. The plurality of light emitting elements are located on the base substrate 110, and include a first light emitting element 120G; each of the plurality of light emitting elements includes a first electrode 140, a light emitting function layer 150, and a second electrode 160. The pixel definition layer 130 includes a first pixel opening 131, the first pixel opening 131 is located on a side of the first electrode 140 of the first light emitting element 120G away from the base substrate 110, and exposes at least a part of the first electrode 140, a light emitting function layer 150 of the first light emitting element 120G is arranged in contact with the first electrode 140 of the first light emitting element 120G through the first pixel opening 131, the second electrode 160 of the first light emitting element 120G is located on a side of the light emitting function layer 150 away from the first electrode 140. In the first light emitting element 120G, the light emitting function layer 150 can realize light emitting display under the driving of the current between the first electrode 140 and the second electrode 160. It should be noted that, the above-mentioned light emitting function layer may include a plurality of light emitting layers, a charge generation layer and other auxiliary function layers for assisting light emission, such as a hole transport layer, and an electron transport layer.

As illustrated by Fig. 1, the pixel definition layer 130 further includes a first isolation opening 132, which is located at a periphery of the first pixel opening 131 and is configured to expose the pixel isolation structure. At this time, the pixel definition layer 130 includes a first pixel definition part 130A located between the first pixel opening 131 and the first isolation opening 132 and a second pixel definition part 130B located on a side of the first isolation opening 132 away from the first pixel opening 131. The first pixel definition part 130A covers an edge of the first electrode 140 of the first light emitting element 120G, and plays a role of limiting the light emission angle of the first light emitting element 120G. The second pixel definition part 130B covers an edge of the light emitting element adjacent to the first light emitting element 120G, and can play a role of limiting the light emission angle of the light emitting element.

As illustrated by Fig. 1, the display substrate 100 further includes an isolation function layer 170. The isolation function layer 170 is located between the base substrate 110 and the plurality of light emitting elements 120 in a direction perpendicular to the base substrate 110; the isolation function layer 170 includes a first isolation groove 171, which is configured to at least isolate the charge generation layer in the light emitting function layer. That is, the above-mentioned pixel isolation structure is an isolation groove. However, the embodiments of the present disclosure include but are not limited thereto, the above-mentioned pixel isolation structure may also be other forms of pixel isolation structures, such as pixel isolation columns.

As illustrated by Fig. 1, the light emitting function layer 150 of the first light emitting element 120G includes a first light emitting layer 151, a second light emitting layer 152, and a charge generation layer 153 located between the first light emitting layer 151 and the second light emitting layer 152. The charge generation layer has strong conductivity, which can make the light emitting function layer have the advantages of long life, low power consumption and high brightness. For example, compared with a light emitting function layer without a charge generation layer, the first light emitting element can increase the light emitting brightness by nearly double by providing a charge generation layer in the light emitting function layer. At the same time, as illustrated by Fig. 1, because the pixel definition layer 130 is arranged with a first isolation opening 132, the pixel isolation structure is arranged below the first isolation opening 132. Therefore, a charge generation layer is disconnected at a position where the pixel isolation structure 171 is located in the first isolation opening 132. In this way, the display substrate can prevent the charge generation layer with higher conductivity in the light emitting function layer from causing crosstalk between adjacent light emitting elements.

In summary, the display substrate can realize a double-layer light emitting (Tandem EL) design, and thus has the advantages of long life, low power consumption, and high brightness. Furthermore, the display substrate can also avoid crosstalk between adjacent light emitting elements through the above-mentioned first isolation opening and pixel isolation structure. It should be noted that conductivity of the charge generation layer is greater than conductivity of the first light emitting layer and conductivity of the second light emitting layer, and is less than conductivity of the second electrode. In addition, the light emitting function layer may further include other sub-function layers in addition to the charge generation layer, the first light emitting layer and the second light emitting layer, for example, a hole injection layer, a hole transport layer, an electron injection layer and an electron transport layer.

On the other hand, the inventors of the present application noticed that because a distance between the pixel opening and the isolation opening in the light emitting element is relatively close, due to the presence of an exposure diffraction effect, the pixel definition layer between the pixel opening and the isolation opening is jointly affected by the exposure diffraction effect of the pixel opening and the isolation opening during the exposure process, thus the pixel definition layer may be excessively thinned or even partially removed. In this way, this phenomenon may cause the pixel definition layer to fail to completely cover an edge of the anode, which causes a micro short circuit between the anode and the cathode, resulting in defects such as dark spots; in addition, this phenomenon causes slope angles of edge profiles of pixel definition layers of different light emitting elements to differ, which will cause the light output angles of different light emitting elements to be unbalanced, resulting in color shift.

As illustrated by Fig. 1, because a distance between the first pixel opening 131 and the first isolation opening 132 is relatively short, due to the presence of the exposure diffraction effect, the first pixel definition part 130A between the first pixel opening 131 and the first isolation opening 132 is jointly affected by the exposure diffraction effect of the first pixel opening 131 and the first isolation opening 132, the first pixel definition part 130A will be excessively thinned or even partially removed. In this way, a maximum height of the first pixel definition part 130A is smaller than a maximum height of the second pixel definition part 130B; and a slope angle of an edge profile of the first pixel definition part 130A is also smaller than a slope angle of an edge profile of the second pixel definition part 130B.

Fig. 2 is a focused ion beam scanning electron microscope diagram of a display substrate provided by an embodiment of the present disclosure. The pixel definition layer in the display substrate shown in Fig. 2 adopts the same design as that in Fig. 1. As illustrated by Fig. 2, the pixel definition layer 130 at an edge of the first electrode 140 is relatively thin, and a minimum slope angle is only 13 degrees, conductive metal particles (for example, silver particles) at an edge of the first electrode 140 pass through the pixel definition layer 130, and short circuit occurs between the conductive metal particles at the edge of the first electrode 140 and the second electrode 160, thus defects such as dark spots are likely to occur, and risks such as electrostatic discharge may also be likely to occur.

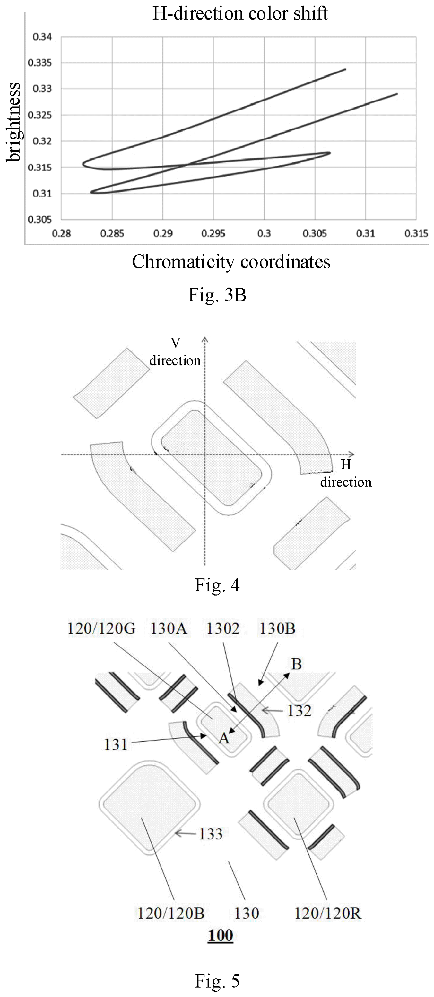

Fig. 3A is a H-direction color shift test diagram of a display substrate provided by an embodiment of the present disclosure; Fig. 3B is a V-direction color shift test diagram of a display substrate provided by an embodiment of the present disclosure; and Fig. 4 is a schematic diagram of a color shift test direction of a display substrate provided by an embodiment of the present disclosure. As illustrated by Fig. 3A, because the light emitting elements do not have the above-mentioned isolation opening in the V direction, the impact is small, but color deviation of the light emitting element in the H direction is more serious.

In order to solve the above-mentioned dark spot and color shift problems, the embodiment of the present disclosure further provides a display substrate. The display substrate comprises a base substrate, a plurality of light emitting elements and a pixel definition layer; the plurality of light emitting elements are located on a substrate; each of the plurality of light emitting elements includes a first electrode, a light emitting function layer, and a second electrode, and the plurality of light emitting elements include a first light emitting element; the pixel definition layer includes a first pixel opening and a first isolation opening, the first pixel opening is located at a side of a first electrode of the first light emitting element away from the base substrate and exposes at least a part of the first electrode, the first isolation opening is located at a periphery of the first pixel opening; the pixel definition layer includes a first pixel definition part located between the first pixel opening and the first isolation opening and a second pixel definition part located on a side of the first isolation opening away from the first pixel opening; the first pixel definition part includes a first main body part and a first compensation part that are connected with each other, the first compensation part is located on a side of the first main body part close to the first isolation opening, the first compensation part has a first protruding profile protruding from a top of the first main body part toward a direction away from the base substrate, to make that a maximum height of the first compensation part is greater than a maximum height of the first main body part. In this way, the display substrate reduces or even eliminates the adverse effects of the exposure diffraction effect on the first pixel definition part by adding a first compensation part at an edge of the first pixel definition part next to the first isolation opening, thus the first pixel definition part next to the first isolation opening is prevented from being excessively thinned, thereby avoiding dark spots and color shift problems.

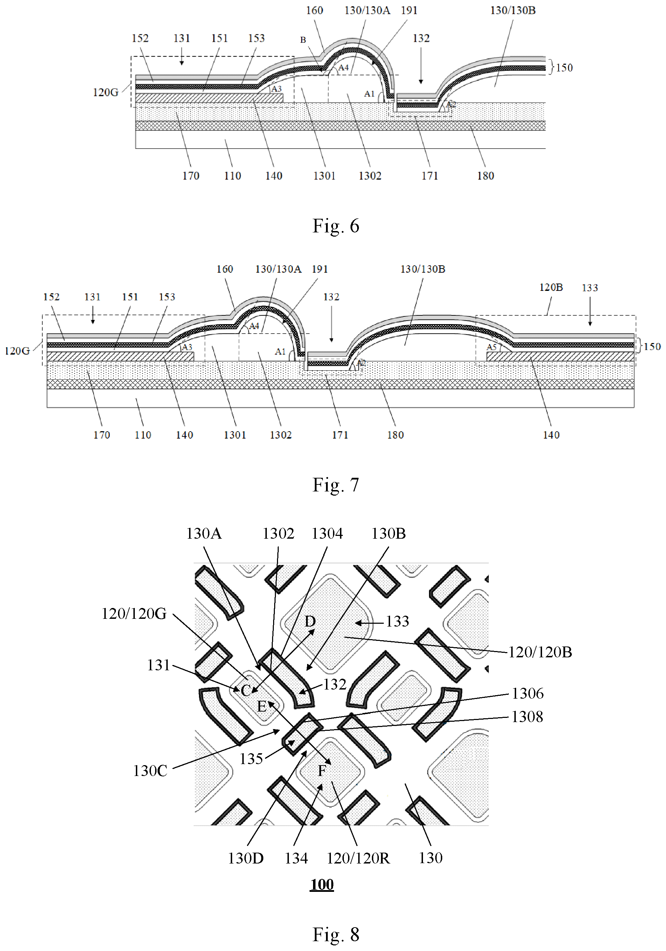

Fig. 5 is a planar schematic diagram of a display substrate provided by an embodiment of the present disclosure; and Fig. 6 is a cross-sectional schematic diagram of a display substrate along the AB direction in Fig. 5 provided by an embodiment of the present disclosure.

As illustrated by Fig. 5 and Fig. 6, the display substrate 100 includes a base substrate 110, a plurality of light emitting elements 120 and a pixel definition layer 130. The plurality of light emitting elements 120 are located on the base substrate 110 and include a first light emitting element 120G; each of the plurality of light emitting elements 120 includes a first electrode 140, a light emitting function layer 150, and a second electrode 160. The pixel definition layer 130 includes a first pixel opening 131, the first pixel opening 131 is located at a side of a first electrode 140 of the first light emitting element 120G away from the base substrate 110, and exposes at least a part of the first electrode 140, a light emitting function layer 150 of the first light emitting element 120G is arranged in contact with the first electrode 140 of the first light emitting element 120G through the first pixel opening 131, and a second electrode 160 of the first light emitting element 120G is located on a side of the light emitting function layer 150 away from the first electrode 140. In the first light emitting element 120G, driven by a current between the first electrode 140 and the second electrode 160, the light emitting function layer 150 can realize light emitting display. It should be noted that the above-mentioned light emitting function layer may include a plurality of light emitting layers, a charge generation layer and other auxiliary function layers for assisting light emission, such as a hole transport layer and an electron transport layer.

For example, the first electrode 140 may be an anode, and the second electrode 160 may be a cathode; and the plurality of light emitting elements 120 may share the second electrode 160. For example, the cathode may be made of a material with high conductivity and low work function, for example, the cathode may be made of a metal material. For example, the anode may be made of a transparent conductive material having a high work function. Of course, the embodiments of the present disclosure include but are not limited thereto, and the first electrode may also be the cathode, and the second electrode may be the anode.

For example, the first electrode 140 may be made of a metal material, such as any one or more of magnesium (Mg), silver (Ag), copper (Cu), aluminum (Al), titanium (Ti), and molybdenum (Mo), or alloy materials of the above metals, such as aluminum-neodymium alloy (AlNd) or molybdenum-niobium alloy (MoNb), the first electrode 140 can be a single-layer structure or a multi-layer composite structure, such as Ti/Al/Ti, or can be a stacked structure made of metal and transparent conductive materials, for example, reflective materials such as ITO/Ag/ITO, and Mo/AlNd/ITO.

For example, the second electrode 160 may be made of any one or more of magnesium (Mg), silver (Ag), and aluminum (Al), or alloys made of any one or more of the above metals, or made of transparent conductive materials, such as indium tin oxide (ITO), or a multilayer composite structure of metal and transparent conductive material.

As illustrated by Fig. 6, the pixel definition layer 130 further includes a first isolation opening 132, which is located at a periphery of the first pixel opening 131 and is configured to expose the pixel isolation structure. At this time, the pixel definition layer 130 includes a first pixel definition part 130A located between the first pixel opening 131 and the first isolation opening 132 and a second pixel definition part 130B located at a side of the first isolation opening 132 away from the first pixel opening 131. The first pixel definition part 130A covers an edge of the first electrode 140 of the first light emitting element 120G, and can play a role in limiting a light emission angle of the first light emitting element 120G, the second pixel definition part 130B covers an edge of the light emitting element adjacent to the first light emitting element 120G, and can play a role of limiting a light emission angle of the light emitting element.

As illustrated by Fig. 6, the first pixel definition part 130A includes a first main body part 1301 and a first compensation part 1302 that are connected with each other. The first compensation part 1302 is located on a side of the first main body part 1301 close to the first isolation opening 132, the first compensation part 1302 has a first protruding profile 191 protruding from a top of the first main body part 1301 in a direction away from the base substrate 110, to make that a maximum height of the first compensation part 1302 is greater than a maximum height of the first main body part 1301. It should be noted that the above-mentioned "maximum height" may be a maximum dimension of the compensation part or the main body part in a direction perpendicular to the base substrate, may also be a maximum distance between the upper surface of the compensation part or the main body part away from the base substrate and the base substrate or the isolation function layer described later.

In the display substrate provided by the embodiment of the present disclosure, because the first pixel definition part includes the first compensation part, the first compensation part has a first protruding profile protruding from a top of the first main body part toward a direction away from the base substrate, so that a maximum height of the first compensation part is greater than a maximum height of the first main body part, therefore, the first compensation part can play a certain role of blocking light during the exposure process, to alleviate or even eliminate the adverse effects of the exposure diffraction effect on the first pixel definition part, thus the first pixel definition part next to the first isolation opening is prevented from being excessively thinned, and defects such as dark spots caused by the first pixel definition part failing to completely cover an edge of the first electrode can be avoided, a slope angle of an edge profile of the first pixel definition part close to the first pixel opening can be kept relatively consistent with slope angles of the edges of other pixel openings, thus color shift is avoided.

In some examples, the first main body part 1301 and the first compensation part 1302 included in the first pixel definition part 130A are integrally formed.

In some examples, the material of the pixel definition layer 130 may be a photosensitive material, such as a photosensitive resin. In this way, the pixel definition layer can be patterned only through an exposure process. In addition, in order to form the first compensation part and the first main body part with different heights, a half-tone mask or a double mask process may be used, and the embodiments of the present disclosure are not limited herein.

In the display substrate provided by the embodiment of the present disclosure, the first compensation part 1302 can be reused as a spacer.

For example, the maximum height of the first main body part 1301 may range from 0 micrometer to 0.8 micrometers. At this time, a maximum height of the first compensation part 1302 in the direction perpendicular to the base substrate 110 ranges from 0.9 micrometers to 1.3 micrometers.

For example, difference between the maximum height of the first compensation part 1302 and the maximum height of the first main body part 1301 is in the range of 0.1 micrometers to 0.5 micrometers.

For example, the difference between the maximum height of the first compensation part 1302 and the maximum height of the first main body part 1301 is 0.25 micrometers. In some examples, as illustrated by Fig. 6, the light emitting function layer 150 of the first light emitting element 120G includes a first light emitting layer 151, a second light emitting layer 152, and a charge generation layer 153 located between the first light emitting layer 151 and the second light emitting layer 152. The charge generation layer has strong conductivity, which can make the light emitting function layer have the advantages of long life, low power consumption and high brightness, for example, compared with a light emitting function layer without a charge generation layer, the first light emitting element can increase the light emitting brightness by nearly double by arranging a charge generation layer in the light emitting function layer. At the same time, as illustrated by Fig. 6, because the pixel definition layer 130 is provided with a first isolation opening 132, a pixel isolation structure is disposed below the first isolation opening 132, the charge generation layer is disconnected at the position where the pixel isolation structure 171 is located in the first isolation opening 132. In this way, the display substrate can prevent the charge generation layer with higher conductivity in the light emitting function layer from causing crosstalk between adjacent light emitting elements.

In some examples, the charge generation layer 153 may include an n-type doping layer for generating holes and a p-type doping layer for generating electrons, which are stacked. For example, the material of the charge generation layer 153 may include an n-type doped organic layer/a p-type doped organic layer, such as BPhen:Cs/NPB:F4-TCNQ, Alq₃:Li/NPB:FeCl₃, TPBi:Li/NPB:FeCl₃, and Alq₃:Mg/m-MTDATA:F4-TCNQ. Of course, the embodiments of the present disclosure include but are not limited thereto, the material of the charge generation layer may also include an n-type doped organic layer/inorganic metal oxide, such as Alq₃:Mg/WO₃, Bphen:Li/MoO₃, BCP:Li/V₂O₅ and BCP:Cs/V₂O₅; or an n-type doped organic layer/organic layer, such as Alq₃:Li/HAT-CN; or non-doped materials such as F₁₆CuPc/CuPc and Al/WO₃/Au.

In some examples, the materials of the first light emitting layer 151 and the second light emitting layer 152 may be at least one selected from a group consisting of pyrene derivatives, anthracene derivatives, fluorene derivatives, perylene derivatives, styrylamine derivatives and metal complexes.

Of course, in addition to the above-mentioned first light emitting layer 151, the second light emitting layer 152 and the charge generation layer 153, the light emitting function layer 150 may further include other auxiliary function layers for assisting light emission, such as a hole injection layer, a hole transport layer, an electron injection layer, and an electron transport layer.

For example, a material of the hole injection layer may include oxides such as molybdenum oxide, titanium oxide, vanadium oxide, rhenium oxide, ruthenium oxide, chromium oxide, zirconium oxide, hafnium oxide, tantalum oxide, silver oxide, tungsten oxide, and manganese oxide.

For example, the material of the hole injection layer may also include organic materials, such as: hexacyanohexaazatriphenylene, 2,3,5,6-tetrafluoro-7,7,8,8-tetracyanoquinodimethane (F4TCNQ), and 1,2,3-tris[(cyano) (4-cyano-2,3,5,6-tetrafluorophenyl)methylene]cyclopropane.

For example, a material of the hole transport layer may include aromatic amines having hole transport properties and dimethylfluorene or carbazole materials, for example: 4,4'-bis[N-(1-naphthyl)-N-phenylamino]biphenyl (NPB), N,N'-bis(3-methylphenyl)-N,N'-diphenyl-[1,1'-biphenyl]-4,4'-diamine (TPD), 4-phenyl-4'-(9-phenylfluoren-9-yl)triphenylamine (BAFLP), 4,4'-bis[N-(9,9-dimethylfluoren-2-yl)-N-phenylamino]biphenyl (DFLDPBi), 4,4'-di(9-carbazolyl)biphenyl (CBP), and 9-phenyl-3-[4-(10-phenyl-9-anthracenyl)phenyl]-9H-carbazole (PCzPA).

For example, a material of the electron transport layer may include an aromatic heterocyclic compound, such as a benzimidazole derivative, an imidazole derivative, a pyrimidine derivative, an oxazine derivative, a quinoline derivative, an isoquinoline derivative and a phenanthroline derivative.

For example, a material of the electron injection layer may be an alkali metal or a metal and a compound thereof, such as lithium fluoride (LiF), ytterbium (Yb), magnesium (Mg), and calcium (Ca).

In some examples, as illustrated by Fig. 6, one end of the first protruding profile 191 is located at a top of the first body part 1301, and the other end of the first protruding profile 191 is located at an edge of the first isolation opening 132. Along a direction from the first pixel opening 131 to the first isolation opening 132, a distance between the first protruding profile 191 and the base substrate 110 increases first and then decreases.

In some examples, as illustrated by Fig. 6, the first protruding profile 191 intersects with an upper surface of the first main body part 1301 away from the base substrate 110 at an inflection point, and an angle B between a tangent passing through the inflection point and tangent to the first protrusion profile 191 and a tangent passing through the inflection point and tangent to the upper surface is less than 180 degrees.

In some examples, as illustrated by Fig. 6, the edge profile of the first pixel definition part 130A close to the first isolation opening 132 has a first slope angle A1, the edge profile of the second pixel definition part 130B close to the first isolation opening 132 has a second slope angle A2, and a difference between the first slope angle A1 and the second slope angle A2 ranges from 0 to 40 degrees. It should be noted that the above-mentioned slope angle may be the angle between a bottom surface of the pixel definition part and a tangent line passing through a point on the edge of the profile and being tangent to the profile.

For example, as illustrated by Fig. 6, the first slope angle A1 is greater than the second slope angle A2, and a difference between the first slope angle A1 and the second slope angle A2 ranges from 20 degrees to 40 degrees.

In some examples, as illustrated by Fig. 6, the edge profile of the first pixel definition part 130A close to the first pixel opening 131 has a third slope angle A3, and a difference between the third slope angle A3 and the first slope angle A1 ranges from 20 degrees to 40 degrees.

In some examples, as illustrated by Fig. 6, a difference between the third slope angle A3 and the second slope angle A2 is less than 5 degrees. Due to the existence of the first compensation part, the edge profile of the first pixel definition part close to the first pixel opening will not be over-etched, therefore, a difference in slope angles between the edge profiles of the first pixel definition part and the second pixel definition part is small, thereby avoiding color shift.

For example, as illustrated by Fig. 6, the difference between the third slope angle A3 and the second slope angle A2 is less than 3 degrees, which can further avoid color shift.

In some examples, as illustrated by Fig. 6, the maximum height of the first main body part 1301 is the same as a maximum height of the second pixel definition part 130B, and a maximum height of the first compensation part 1302 is greater than the maximum height of the first main body part 1301. In this way, the first compensation part 1302 can block light during the exposure process, thus the adverse influence of the exposure diffraction effect on the first pixel definition part is reduced, and the slope angle of the edge profile of the first pixel definition part close to the first pixel opening is improved.

In some examples, as illustrated by Fig. 6, the first protruding profile 191 has a fourth slope angle A4 on a side close to the first main body part 1301, and a value range of the fourth slope angle A4 is from 0 degree to 20 degrees.

In some examples, as illustrated by Fig. 6, a direction from the first pixel opening 131 to the first isolation opening 132 is the first direction, a ratio of a width of the first compensation part 1302 in the first direction to a width of the first main body part 1301 in the first direction is in a range of 0 to 0.3. In this way, the display substrate can avoid the first compensation part being too large, thus it is avoided that a difference between a slope angle of an edge profile of the first main body part and a slope angle of an edge profile of the pixel definition part of other light emitting elements becomes larger.

For example, as illustrated by Fig. 6, the width of the first pixel definition part 130A in the first direction is 6.7 micrometers, the width of the first compensation part 1302 in the first direction ranges from 4.7 micrometers to 6.2 micrometers, and the width of the first main body part 1301 in the first direction may range from 0.5 micrometers to 2.0 micrometers.

For example, as illustrated by Fig. 6, the width of the first pixel definition part 130A in the first direction is 6.7 micrometers, the width of the first compensation part 1302 in the first direction is 5.2 micrometers, and the width of the first main body part 1301 in the first direction is 1.5 micrometers.

For example, as illustrated by Fig. 6, the width of the first pixel definition part 130A in the first direction is 6.7 micrometers, the width of the first compensation part 1302 in the first direction is 4.7 micrometers, and the width of the first main body part 1301 in the first direction is 2 micrometers.

In some examples, as illustrated by Fig. 6, the display substrate 100 further includes an isolation function layer 170, the isolation function layer 170 is located between the base substrate 110 and the plurality of light emitting elements 120 in the direction perpendicular to the base substrate 110; the isolation function layer 170 includes a first isolation groove 171, which configured to at least isolation the charge generation layer in the light emitting function layer; an orthographic projection of the first isolation opening 132 on the base substrate 110 covers an edge of the first isolation groove 171 close to the first pixel opening 131. In this way, the first isolation opening can expose the first isolation groove to prevent the first isolation groove from being covered by the pixel definition layer. On the other hand, the first isolation opening can also increase the step difference, so that the charge generation layer in the light emitting function layer is better isolated.

In some examples, as illustrated by Fig. 6, the light emitting function layer 150 includes a charge generation layer 153, the charge generation layer 153 is disconnected at an edge of the first isolation groove 171 close to the first pixel opening 131. **In** this way, the display substrate can prevent the charge generation layer with higher conductivity in the light emitting function layer from causing crosstalk between adjacent light emitting elements.

**In** some examples, as illustrated by Fig. 6, the first light emitting layer 151 and the second light emitting layer 152 of the light emitting function layer 150 are also disconnected at the edge of the first isolation groove 171 close to the first pixel opening 131. Because the first isolation groove 171 has a good isolation effect, the two light emitting layers of the light emitting function layer 150 can also be disconnected at the edge of the first isolation groove close to the first pixel opening. However, the present disclosure includes but is not limited thereto, the first light emitting layer and the second light emitting layer in the light emitting function layer may not be disconnected at the location where the first isolation groove is located, but only the charge generation layer is disconnected at the position where the first isolation groove is located.

**In** some examples, as illustrated by Fig. 6, the second electrode 160 is also disconnected at an edge of the first isolation groove 171 close to the first pixel opening 131. However, the embodiments of the present disclosure include but are not limited to these, the second electrode may also be kept connected at the position where the first isolation groove is located. For example, the second electrode may be disconnected or not disconnected at the location where the first isolation groove is located by controlling or designing the depth or other parameters of the first isolation groove.

**In** some examples, the isolation function layer 170 may be a newly added film layer or a flat layer in the display substrate.

For example, the material of the isolation function layer 170 may be an organic material or an inorganic material; the organic material may include one or a combination selected from the group consisting of resin, acrylic or polyethylene terephthalate, polyimide, polyamide, polycarbonate, and epoxy resin, and the inorganic material may include silicon oxide, silicon nitride, silicon and oxynitride.

**In** some examples, as illustrated by Fig. 6, the display substrate 100 further includes a pixel driving circuit layer 180, which is configured to provide a driving signal to the light emitting element 120.

In some examples, other film layers are arranged between the isolation function layer 170 and the base substrate 110, these other film layers may include gate insulating layers, interlayer insulating layers, various film layers in the pixel driving circuit layer (for example, including thin film transistors, storage capacitors and other structures), data lines, gate lines, power signal lines, reset power signal lines, reset control signal lines, light emitting control signal lines and other film layers or structures.

In some examples, the base substrate 110 may be made of one or more materials selected from the group consisting of glass, polyimide, polycarbonate, polyacrylate, polyetherimide, and polyethersulfone, and this embodiment includes but is not limited thereto.

In some examples, as illustrated by Fig. 5, orthographic projections of the first isolation opening 132 and the second isolation opening 135 on the base substrate 110 may be in the shape of a strip. Of course, the embodiments of the present disclosure include but are not limited thereto.

For example, as illustrated by Fig. 5, a shape of an orthographic projection of the first isolation opening 132 on the base substrate 110 has a curved part at a position corresponding to the corner part of the first pixel opening 131, and a shape of an orthographic projection of the second isolation opening 135 on the base substrate 110 has a curved part at a position corresponding to the corner part of the first pixel opening 131.

Fig. 7 is a cross-sectional schematic diagram of another display substrate provided by an embodiment of the present disclosure along the AB direction in Fig. 5. Compared with Fig. 6, Fig. 7 shows the structure of other light emitting elements close to the first light emitting element 120G.

As illustrated by Fig. 5 and Fig. 7, the plurality of light emitting elements 120 include a second light emitting element 120B; the pixel definition layer 130 further includes a second pixel opening 133, which is located on a side of the first electrode 140 of the second light emitting element 120B away from the base substrate 110 and exposes at least a part of the first electrode 140, and the light emitting function layer 150 of the second light emitting element 120B is arranged in contact with the first electrode 140 through the second pixel opening 133, and the second electrode 160 of the second light emitting element 120B is located on a side of the light emitting function layer 150 away from the first electrode 140. The second pixel opening 133 is located on a side of the first isolation opening 132 away from the first pixel opening 131, and the second pixel definition part 130B is located between the first isolation opening 132 and the second pixel opening 133.

In some examples, as illustrated by Fig. 7, a size of the second pixel definition part 130B in the first direction is greater than a size of the first pixel definition part 130A in the first direction. The first direction may be a direction from the first pixel opening 131 to the first isolation opening 132. Because the size of the second pixel definition part in the first direction is larger than the size of the first pixel definition part in the first direction, the exposure diffraction effect at the position where the first isolation opening is located and the exposure diffraction effect at the position where the second pixel opening is located cannot be superimposed on an edge of the second pixel opening, thus no adverse effect is caused on the edge profile of the second pixel opening. Therefore, a part of the second pixel definition part close to the first isolation opening may not be arranged with a compensation part similar to the first compensation part. However, the present disclosure includes but is not limited thereto, the part of the second pixel definition part close to the first isolation opening may not be arranged with a compensation part similar to the first compensation part.

In some examples, as illustrated by Fig. 7, an edge profile of the second pixel definition part 130B close to the second pixel opening 133 has a fifth slope angle A5, a difference between the fifth slope angle A5 and the third slope angle A3 of the edge profile of the first pixel definition part 130A close to the first pixel opening 131 is less than 5 degrees. Due to the existence of the first compensation part, the edge profile of the first pixel definition part close to the first pixel opening will not be over-etched, so that the difference in slope angle between the edge profile of the first pixel definition part close to the second pixel opening and the second pixel definition part is small, thereby avoiding color shift.

For example, as illustrated by Fig. 7, the difference between the fifth slope angle A5 and the third slope angle A3 is less than 3 degrees, so that color shift can be further avoided.

In some examples, the first light emitting element 120G is configured to emit light of a first color, and the second light emitting element 120B is configured to emit light of a second color.

For example, the first color may be green and the second color may be blue. Of course, the embodiments of the present disclosure include but are not limited thereto, and the first color and the second color may also be other colors.

An embodiment of the present disclosure provides another display substrate. As illustrated by Fig. 5 and Fig. 6, the display substrate 100 includes a base substrate 110, a plurality of light emitting elements 120 and a pixel definition layer 130. The plurality of light emitting elements 120 are located on the base substrate 110 and include a first light emitting element 120G; each of the plurality of light emitting elements 120 includes a first electrode 140, a light emitting function layer 150, and a second electrode 160. The pixel definition layer 130 includes a first pixel opening 131, the first pixel opening 131 is located at a side of a first electrode 140 of the first light emitting element 120G away from the base substrate 110, and exposes at least a part of the first electrode 140. The light emitting function layer 150 of the first light emitting element 120G is arranged in contact with the first electrode 140 of the first light emitting element 120G through the first pixel opening 131, and the second electrode 160 of the first light emitting element 120G is located on a side of the light emitting function layer 150 away from the first electrode 140. In the first light emitting element 120G, the light emitting function layer 150 can realize light emitting display under the driving of the current between the first electrode 140 and the second electrode 160. It should be noted that the above-mentioned light emitting function layer may include a plurality of light emitting layers, a charge generation layer and other auxiliary function layers for assisting light emission, such as a hole transport layer and an electron transport layer.

For example, the first electrode 140 may be an anode and the second electrode 160 may be a cathode; and the plurality of light emitting elements 120 may share the second electrode 160. For example, the cathode may be formed of a material with high conductivity and low work function, for example, the cathode may be made of a metal material. For example, the anode may be formed of a transparent conductive material having a high work function. Of course, the embodiments of the present disclosure include but are not limited thereto, and the first electrode may also be a cathode and the second electrode may be an anode.

For example, the first electrode 140 may be made of a metal material, such as any one or more of magnesium (Mg), silver (Ag), copper (Cu), aluminum (Al), titanium (Ti), and molybdenum (Mo), or alloy materials of the above metals, such as aluminum-neodymium alloy (AlNd) or molybdenum-niobium alloy (MoNb), can be a single-layer structure or a multi-layer composite structure, such as Ti/Al/Ti, or can be a stacked structure formed by metal and transparent conductive materials, such as reflective materials such as ITO/Ag/ITO and Mo/AlNd/ITO.

For example, the second electrode 160 may be made of any one or more of magnesium (Mg), silver (Ag), and aluminum (Al), or alloys made of any one or more of the above metals, or use transparent conductive materials, such as indium tin oxide (ITO), or a multilayer composite structure of metal and transparent conductive material.

As illustrated by Fig. 6, the pixel definition layer 130 further includes a first isolation opening 132, which is located at a periphery of the first pixel opening 131, and is configured to expose the pixel isolation structure. At this time, the pixel definition layer 130 includes a first pixel definition part 130A located between the first pixel opening 131 and the first isolation opening 132 and a second pixel definition part 130B located at the first isolation opening 132 away from the first pixel opening 131. The first pixel definition part 130A covers an edge of the first electrode 140 of the first light emitting element 120G, and can play a role of limiting the light emission angle of the first light emitting element 120G, the second pixel definition part 130B covers the edge of the light emitting element adjacent to the first light emitting element 120G, and can play a role of limiting the light emission angle of the light emitting element.

As illustrated by Fig. 6, the edge profile of the first pixel definition part 130A close to the first isolation opening 132 has a first slope angle A1, the edge profile of the second pixel definition part 130B close to the first isolation opening 132 has a second slope angle A2, and a difference between the first slope angle A1 and the second slope angle A2 ranges from 0 degree to 40 degrees. It should be noted that the above-mentioned slope angles may be an angle between the bottom surface of the pixel definition part and a tangent line passing through a point on the edge of the profile and being tangent to the profile.

For example, as illustrated by Fig. 6, the first slope angle A1 is greater than the second slope angle A2, and a difference between the first slope angle A1 and the second slope angle A2 ranges from 20 degrees to 40 degrees.

In the display substrate provided by the embodiment of the present disclosure, because the first slope angle of the edge profile of the first pixel definition part close to the first isolation opening is greater than the second slope angle of the edge profile of the second pixel definition part close to the first isolation opening, the edge profile of the first pixel definition part close to the first isolation opening can play a certain role of blocking light during the exposure process, to alleviate or even eliminate the adverse effects of the exposure diffraction effect on the first pixel definition part, thus the first pixel definition part next to the first isolation opening is prevented from being excessively thinned, and defects such as dark spots caused by the first pixel definition part failing to completely cover the edge of the first electrode can be avoided, the slope angle of the edge profile of the first pixel definition part close to the first pixel opening is relatively consistent with the slope angle of the edge of other pixel openings, thus the color shift is avoided.

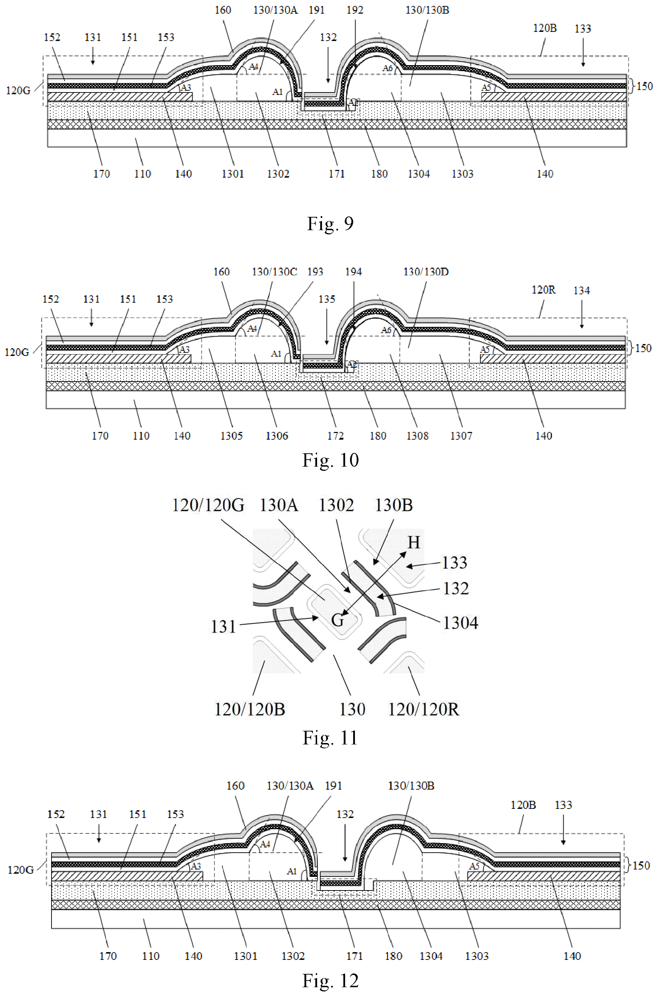

Fig. 8 is a planar schematic diagram of another display substrate provided by an embodiment of the present disclosure; and Fig. 9 is a cross-sectional schematic diagram of a display substrate along the CD direction in Fig. 8 provided by an embodiment of the present disclosure.

As illustrated by Fig. 8 and Fig. 9, the display substrate 100 includes a base substrate 110, a plurality of light emitting elements 120 and a pixel definition layer 130. The plurality of light emitting elements 120 are located on the base substrate 110 and include a first light emitting element 120G; each of the plurality of light emitting elements 120 includes a first electrode 140, a light emitting function layer 150, and a second electrode 160.

As illustrated by Fig. 8 and Fig. 9, the pixel definition layer 130 includes a first pixel opening 131 and a second pixel opening 133; the first pixel opening 131 is located on a side of a first electrode 140 of the first light element 120G away from a side of the base substrate 110, and exposes at least a part of the first electrode 140, the light emitting function layer 150 of the first light emitting element 120G is arranged in contact with the first electrode 140 of the first light emitting element 120G through the first pixel opening 131, a second electrode 160 of the first light emitting element 120G is located at a side of the light emitting function layer 150 away from the first electrode 140; the second pixel opening 133 is located at a side of the first electrode 140 of the second light emitting element 120B away from the base substrate 110, and exposes at least a part of the first electrode 140, the light emitting function layer 150 of the second light emitting element 120B is arranged in contact with the first electrode 140 through the second pixel opening 133, the second electrode 160 of the second light emitting element 120B is located at a side of the light emitting function layer 150 away from the first electrode 140; in the first light emitting element 120G and the second light emitting element 120B, the light emitting function layer 150 can realize light emitting display under the driving of the current between the first electrode 140 and the second electrode 160. It should be noted that the above-mentioned light emitting function layer may include a plurality of light emitting layers, a charge generation layer and other auxiliary function layers for assisting light emission, such as a hole transport layer and an electron transport layer.

For example, the first electrode 140 may be an anode and the second electrode 160 may be a cathode; and the plurality of light emitting elements 120 may share the second electrode 160. For example, the cathode may be made of a material with high conductivity and low work function, for example, the cathode may be made of a metal material. For example, the anode may be made of a transparent conductive material having a high work function. Of course, the embodiments of the present disclosure include but are not limited thereto, the first electrode may also be a cathode, and the second electrode may be an anode.

As illustrated by Fig. 8 and Fig. 9, the pixel definition layer 130 further includes a first isolation opening 132, which is located between the first pixel opening 131 and the second pixel opening 133, and is configured to expose the pixel isolation structure. At this time, the pixel definition layer 130 includes a first pixel definition part 130A located between the first pixel opening 131 and the first isolation opening 132 and a second pixel definition part 130B located at a side of the first isolation opening 132 away from the first pixel opening 131. The first pixel definition part 130A covers an edge of the first electrode 140 of the first light emitting element 120G, and can play a role of limiting the light emission angle of the first light emitting element 120G, and the second pixel definition part 130B covers an edge of the first electrode 140 of the second light emitting element 120B, and can play a role of limiting the light emission angle of the second light emitting element 120B.

As illustrated by Fig. 9, the first pixel definition part 130A includes a first main body part 1301 and a first compensation part 1302 that are connected with each other, the first compensation part 1302 is located on a side of the first main body part 1301 close to the first isolation opening 132, the first compensation part 1302 has a first protruding profile 191 protruding from the top of the first main body part 1301 in a direction away from the base substrate 110, so that a maximum height of the first compensation part 1302 is greater than the maximum height of the first main body part 1301.

As illustrated by Fig. 9, the second pixel definition part 130B includes a second main body part 1303 and a second compensation part 1304 that are connected with each other, the second compensation part 1304 is located on a side of the second main body part 1303 close to the first isolation opening 132, the second compensation part 1304 has a second protruding profile 192 protruding from a top of the second main body part 1303 in a direction away from the base substrate 110, so that a maximum height of the second compensation part 1304 is greater than a maximum height of the second main body part 1303.

In the display substrate provided by the embodiment of the present disclosure, because the first pixel definition part includes a first compensation part, the second pixel definition part includes a second compensation part, the first compensation part having a first protruding profile protruding from a top of the first main body part in a direction away from the base substrate, so that the maximum height of the first compensation part is greater than the maximum height of the first main body part, the second compensation part has a second protruding profile protruding from a top of the second main body part in a direction away from the base substrate, so that the maximum height of the second compensation part is greater than the maximum height of the second main body part, therefore, the first compensation part and the second compensation part can play a certain role of blocking light during the exposure process, to alleviate or even eliminate the adverse effects of the exposure diffraction effect on the first pixel definition part and the second pixel definition part, thus the first pixel definition part and the second pixel definition part next to the first isolation opening are prevented from being excessively thinned, and thus defects such as dark spots caused by the first pixel definition part and the second pixel definition part failing to completely cover the edge of the first electrode can be avoided, so that a slope angle of an edge profile of the first pixel definition part close to the first pixel opening is kept relatively consistent with a slope angle of an edge profile of the second pixel definition part close to the second pixel opening and slopes of edges of other pixel openings, thus color shift is avoided.

In the display substrate provided by the embodiment of the present disclosure, the second compensation part 1304 may also be reused as a spacer.

For example, the maximum height of the second main body part 1303 may range from 0 micrometer to 0.8 micrometers, at this time, the maximum height of the second compensation part 1304 in a direction perpendicular to the base substrate 110 ranges from 0.9 micrometers to 1.3 micrometers.

For example, a difference between the maximum height of the second compensation part 1304 and the maximum height of the second main body part 1303 is in the range of 0.1 micrometers to 0.5 micrometers.

For example, the difference between the maximum height of the second compensation part 1304 and the maximum height of the second main body part 1303 is 0.25 micrometers.

In some examples, as illustrated by Fig. 8, the first compensation part 1302 and the second compensation part 1304 are connected at two opposite edges of the first isolation opening 132 in the second direction, to surround the first isolation opening 132, thus a compensation loop is formed. The second direction is perpendicular to the direction from the first pixel opening 131 to the first isolation opening 132, that is, the second direction and the first direction are perpendicular to each other. In this way, the edges of the first isolation opening are all arranged with compensation parts, thus the exposure diffraction effect at the location of the first isolation opening can be blocked to the greatest extent. Of course, the embodiments of the present disclosure include but are not limited thereto, the compensation ring may not be formed, but compensation parts may be arranged only on two opposite edges of the first isolation opening in the first direction.

In some examples, as illustrated by Fig. 9, one end of the second protruding profile 192 is located at the top of the second body part 1303, and the other end of the second protruding profile 192 is located at an edge of the first isolation opening 132. Along the direction from the second pixel opening 133 to the first isolation opening 132, the distance between the second protruding profile 192 and the base substrate 110 increases first and then decreases.

In some examples, as illustrated by Fig. 9, the second protruding profile 192 intersects with an upper surface of the second main body part 1303 away from the base substrate 110 at an inflection point, and an angle between the tangent line passing through the inflection point and tangent to the second protruding profile 192 and the tangent line passing through the inflection point and tangent to the upper surface is less than 180 degrees.

In some examples, as illustrated by Fig. 9, an edge profile of the first pixel definition part 130A close to the first isolation opening 132 has a first slope angle A1, an edge profile of the second pixel definition part 130B close to the first isolation opening 132 has a second slope angle A2, and the first slope angle A1 and the second slope angle A2 are approximately equal, for example, the difference between the first slope angle A1 and the second slope angle A2 is less than 5 degrees. It should be noted that the above-mentioned slope angle may be an angle between the bottom surface of the pixel definition part and a tangent line passing through a point on the edge of the profile and being tangent to the profile.

In some examples, as illustrated by Fig. 9, an edge profile of the first pixel definition part 130A close to the first pixel opening 131 has a third slope angle A3, and a difference between the third slope angle A3 and the first slope angle A1 ranges from 20 degrees to 40 degrees.

In some examples, as illustrated by Fig. 9, an edge profile of the second pixel definition part 130B close to the second pixel opening 133 has a fifth slope angle A5, and a difference between the fifth slope angle A5 and the second slope angle A2 ranges from 20 degrees to 40 degrees.

In some examples, as illustrated by Fig. 9, the difference between the third slope angle A3 and the fifth slope angle A5 is less than 5 degrees.

In some examples, as illustrated by Fig. 9, the first protruding profile 191 has a fourth slope angle A4 on a side close to the first main body part 1301, a value range of the fourth slope angle A4 is 0 degree to 20 degrees, and the fourth slope angle A4 can be 5 degrees to 10 degrees.

In some examples, as illustrated by Fig. 9, the second protruding profile 192 has a sixth slope angle A6 on a side close to the second main body part 1303, a value range of the sixth slope angle A6 is 0 degree to 20 degrees, and the sixth slope angle A6 can be 5 degrees to 10 degrees.

In some examples, as illustrated by Fig. 9, the display substrate 100 further includes a pixel driving circuit layer 180, which is configured to provide a driving signal to the light emitting element 120.

In some examples, other film layers are disposed between the isolation function layer 170 and the base substrate 110, these other film layers may include gate insulating layers, interlayer insulating layers, various film layers in pixel driving circuit layers (for example, including thin film transistors, storage capacitors and other structures), data lines, gate lines, power signal lines, reset power signal lines, reset control signal lines, light emitting control signal lines and other film layers or structures.

Fig. 10 is a cross-sectional schematic diagram of a display substrate along the direction EF in Fig. 8 provided by an embodiment of the present disclosure. As illustrated by Fig. 10, the plurality of light emitting elements 120 include a third light emitting element 120R, the pixel definition layer 130 further includes a third pixel opening 134; the third pixel opening 134 is located at a side of the first electrode 140 of the third light emitting element 120R away from the base substrate 110 and exposes at least a part of the first electrode 140, the light emitting function layer 150 of the second light emitting element 120R is arranged in contact with the first electrode 140 through the third pixel opening 134, and the second electrode 160 of the second light emitting element 120R is located on a side of the light emitting function layer 150 away from the first electrode 140. In the first light emitting element 120R, a current between the first electrode 140 and the second electrode 160 can drive the light emitting function layer 150 to emit light.

As illustrated by Fig. 10, the pixel definition layer 130 further includes a second isolation opening 135 located between the first pixel opening 131 and the third pixel opening 134, the second isolation opening 135 is configured to expose the pixel isolation structure between the first pixel opening 131 and the third pixel opening 134. At this time, the pixel definition layer 130 includes a third pixel definition part 130C located between the first pixel opening 131 and the second isolation opening 135 and a fourth pixel definition part 130D located between the second isolation opening 135 and the third pixel opening 134. The third pixel definition part 130C covers an edge of the first electrode 140 of the first light emitting element 120G, to define a light emitting angle of the first light emitting element 120G together with the first pixel definition part 130A, and the fourth pixel definition part 130D covers the edge of the first electrode 140 of the third light emitting element 120R, to limit the light emission angle of the third light emitting element 120R.

As illustrated by Fig. 10, the third pixel definition part 130C includes a third main body part 1305 and a third compensation part 1306 that are connected with each other, the third compensation part 1306 is located on a side of the third main body part 1305 close to the second isolation opening 135, and the third compensation part 1306 has a third protruding profile 193 protruding from the top of the third main body part 1305 in a direction away from the base substrate 110, so that a maximum height of the third compensation part 1306 is greater than a maximum height of the third main body part 1305.

In this example, the third compensation part can play a certain role of blocking light during the exposure process, to alleviate or even eliminate the adverse effect of the exposure diffraction effect at the location of the second isolation opening on the third pixel definition part, thus the third pixel definition part next to the second isolation opening is prevented from being excessively thinned, and thus defects such as dark spots caused by the failure of the third pixel definition part to completely cover the edge of the first electrode can be avoided, so that a slope angle of the edge profile of the third pixel definition part close to the first pixel opening is kept relatively consistent with a slope angle of the edge profile of other pixel definition parts, thus color shift is avoided.

In the display substrate provided by the embodiment of the present disclosure, the third compensation part 1306 mentioned above can also be reused as a spacer. For example, a maximum height of the third main body part 1305 may range from 0 micrometer to 0.8 micrometers. At this time, a maximum height of the third compensation part 1306 in the direction perpendicular to the base substrate 110 ranges from 0.9 micrometers to 1.3 micrometers. As illustrated by Fig. 10, the fourth pixel definition part 130D includes a fourth main body part 1307 and a fourth compensation part 1308 that are connected with each other, the fourth compensation part 1308 is located on a side of the fourth main body part 1307 close to the second isolation opening 135, the fourth compensation part 1308 has a fourth protruding profile 194 protruding from a top of the fourth main body part 1307 in a direction away from the base substrate 110, so that the maximum height of the fourth compensation part 1308 is greater than the maximum height of the fourth main body part 1307.

In this example, the fourth compensation part can play a certain role of blocking light during the exposure process, to alleviate or even eliminate the adverse effect of the exposure diffraction effect at the location of the second isolation opening on the fourth pixel definition part, thus the fourth pixel definition part next to the second isolation opening is prevented from being excessively thinned, and thus defects such as dark spots caused by the fourth pixel definition part failing to completely cover the edge of the first electrode can be avoided, so that a slope angle of the edge profile of the fourth pixel definition part close to the third pixel opening is kept relatively consistent with slope angles of the edge profiles of other pixel definition parts, thus color shift is avoided.

In the display substrate provided by the embodiment of the present disclosure, the fourth compensation part 1308 mentioned above can also be reused as a spacer. For example, the maximum height of the fourth main body part 1307 may range from 0 micrometer to 0.8 micrometers, at this time, the maximum height of the fourth compensation part 1308 in a direction perpendicular to the base substrate 110 ranges from 0.9 micrometers to 1.3 micrometers.

In some examples, as illustrated by Fig. 10, one end of the third protruding profile 193 is located at a top of the third main body part 1305, and the other end of the third protruding profile 193 is located at an edge of the second isolation opening 135. Along a direction from the first pixel opening 131 to the second isolation opening 135, a distance between the third protruding profile 193 and the base substrate 110 increases first and then decreases.

In some examples, as illustrated by Fig. 10, the third protruding profile 193 intersects with an upper surface of the third main body part 1305 away from the base substrate 110 at an inflection point, and an angle between a tangent line passing through the inflection point and tangent to the third protruding profile 193 and a tangent line passing through the inflection point and tangent to the upper surface is less than 180 degrees.

In some examples, as illustrated by Fig. 10, one end of the fourth protruding profile 194 is located at the top of the fourth body part 1307, and the other end of the fourth protruding profile 194 is located at an edge of the second isolation opening 135. Along a direction from the third pixel opening 134 to the second isolation opening 135, a distance between the fourth protruding profile 194 and the base substrate 110 increases first and then decreases.

In some examples, as illustrated by Fig. 10, the fourth protruding profile 194 intersects with an upper surface of the fourth body part 1307 away from the base substrate 110 at an inflection point, and an angle between a tangent line passing through the inflection point and tangent to the fourth protruding profile 194 and a tangent line passing through the inflection point and tangent to the upper surface is less than 180 degrees.

In some examples, the first light emitting elements 120G are configured to emit light of a first color, the second light emitting elements 120B are configured to emit light of a second color, and the third light emitting elements 120R are configured to emit light of a third color.

For example, the first color may be green, the second color may be blue, and the third color may be red. Of course, the embodiments of the present disclosure include but are not limited thereto, and the first color, the second color, and the third color may also be other colors.

In some examples, as illustrated by Fig. 10, the display substrate 100 further includes an isolation function layer 170, the isolation function layer 170 is located between the base substrate 110 and the plurality of light emitting elements 120 in a direction perpendicular to the base substrate 110; the isolation function layer 170 includes a second isolation groove 172, which is configured to at least isolate the charge generation layer in the light emitting function layer; an orthographic projection of the second isolation opening 135 on the base substrate 110 covers an edge of the second isolation groove 172 close to the first pixel opening 131. In this way, the second isolation opening can expose the second isolation groove, to prevent the second isolation groove from being covered by the pixel definition layer, on the other hand, the second isolation opening can also increase the step difference, so that the charge generation layer in the light emitting function layer is better isolated.

In some examples, as illustrated by Fig. 10, the light emitting function layer 150 includes a charge generation layer 153, and the charge generation layer 153 is disconnected at an edge of the second isolation groove 172 close to the first pixel opening 131. In this way, the display substrate can prevent the charge generation layer with higher conductivity in the light emitting function layer from causing crosstalk between adjacent light emitting elements.

In some examples, as illustrated by Fig. 10, the first light emitting layer 151 and the second light emitting layer 152 of the light emitting function layer 150 are also disconnected at an edge of the second isolation groove 172 close to the first pixel opening 131. Because the second isolation groove 172 has a good isolation effect, the two light emitting layers of the light emitting function layer 150 can also be disconnected at the edge of the second isolation groove close to the first pixel opening. However, the embodiments of the present disclosure include but are not limited thereto, the first light emitting layer and the second light emitting layer in the light emitting function layer may not be disconnected at the position where the second isolation groove is located, but only the charge generation layer is disconnected at the position where the second isolation groove is located.

In some examples, as illustrated by Fig. 10, the second electrode 160 is also disconnected at an edge of the second isolation groove 172 close to the first pixel opening 131. However, the embodiments of the present disclosure include but are not limited thereto, and the second electrode may also be kept connected at the location where the second isolation groove is located. For example, the second electrode may be disconnected or not disconnected at the position where the first isolation groove is located by controlling or designing a depth or other parameters of the second isolation groove.

In some examples, as illustrated by Fig. 8, orthographic projections of the first isolation opening 132 and the second isolation opening 135 on the base substrate 110 may be in the shape of a strip. Of course, the embodiments of the present disclosure include but are not limited thereto.

For example, as illustrated by Fig. 8, a shape of an orthographic projection of the first isolation opening 132 on the base substrate 110 has a curved part at a position corresponding to the corner part of the first pixel opening 131, and a shape of an orthographic projection of the second isolation opening 135 on the base substrate 110 has a curved part at a position corresponding to the corner of the first pixel opening 131.

Fig. 11 is a planar schematic diagram of another display substrate provided by an embodiment of the present disclosure; and Fig. 12 is a s cross-sectional schematic diagram of a display substrate along the GH direction in Fig. 11 provided by an embodiment of the present disclosure.

As illustrated by Fig. 11 and Fig. 12, the display substrate 100 includes a base substrate 110, a plurality of light emitting elements 120 and a pixel definition layer 130. The plurality of light emitting elements 120 are located on the base substrate 110 and include first light emitting elements 120G; each of the plurality of light emitting elements 120 includes a first electrode 140, a light emitting function layer 150, and a second electrode 160.

As illustrated by Fig. 11 and Fig. 12, the pixel definition layer 130 includes a first pixel opening 131 and a second pixel opening 133; the first pixel opening 131 is located at a side of the first electrode 140 of the first light emitting element 120G away from the base substrate 110, and exposes at least a part of the first electrode 140, the light emitting function layer 150 of the first light emitting element 120G is arranged in contact with the first electrode 140 of the first light emitting element 120G through the first pixel opening 131, the second electrode 160 of the first light emitting element 120G is located at a side of the light emitting function layer 150 away from the first electrode 140; the second pixel opening 133 is located at a side of the first electrode 140 of the second light emitting element 120B away from the base substrate 110, and exposes at least a part of the first electrode 140, the light emitting function layer 150 of the second light emitting element 120B is arranged in contact with the first electrode 140 through the second pixel opening 133, the second electrode 160 of the second light emitting element 120B is located at a side of the light emitting function layer 150 away from the first electrode 140; in the first light emitting element 120G and the second light emitting element 120B, under the driving of the current between the first electrode 140 and the second electrode 160, the light emitting function layer 150 can realize light emitting display. It should be noted that the above-mentioned light emitting function layer may include a plurality of light emitting layers, a charge generation layer and other auxiliary function layers for assisting light emission, such as a hole transport layer and an electron transport layer.

For example, the first electrode 140 may be an anode and the second electrode 160 may be a cathode; and the plurality of light emitting elements 120 may share the second electrode 160. For example, the cathode may be formed of a material with high conductivity and low work function, for example, the cathode may be made of a metal material. For example, the anode may be formed of a transparent conductive material having a high work function. Of course, the embodiments of the present disclosure include but are not limited thereto, and the first electrode may also be a cathode, and the second electrode may be an anode.

As illustrated by Fig. 11 and Fig. 12, the pixel definition layer 130 further includes a first isolation opening 132, which is located between the first pixel opening 131 and the second pixel opening 133, and is configured to expose the pixel isolation structure. At this time, the pixel definition layer 130 includes a first pixel definition part 130A located between the first pixel opening 131 and the first isolation opening 132 and a second pixel definition part 130B located at a side of the first isolation opening 132 away from the first pixel opening 131. The first pixel definition part 130A covers an edge of the first electrode 140 of the first light emitting element 120G, and can play a role of limiting the light emission angle of the first light emitting element 120G, and the second pixel definition part 130B covers an edge of the first electrode 140 of the second light emitting element 120B, and can play a role of limiting the light emission angle of the second light emitting element 120B.

As illustrated by Fig. 12, the first pixel definition part 130A includes a first main body part 1301 and a first compensation part 1302 that are connected with each other, the first compensation part 1302 is located on a side of the first main body part 1301 close to the first isolation opening 132, the first compensation part 1302 has a first protruding profile 191 protruding from a top of the first main body part 1301 in a direction away from the base substrate 110, so that a maximum height of the first compensation part 1302 is greater than a maximum height of the first main body part 1301.

As illustrated by Fig. 12, the second pixel definition part 130B includes a second main body part 1303 and a second compensation part 1304 that are connected with each other, the second compensation part 1304 is located on a side of the second main body part 1303 close to the first isolation opening 132, the second compensation part 1304 has a second protruding profile 192 protruding from a top of the second main body part 1303 in a direction away from the base substrate 110, so that a maximum height of the second compensation part 1304 is greater than a maximum height of the second main body part 1303.

In the display substrate provided by the embodiment of the present disclosure, because the first pixel definition part includes a first compensation part, the second pixel definition part includes a second compensation part, the first compensation part has a first protruding profile protruding from a top of the first main body part toward a direction away from the base substrate, so that a maximum height of the first compensation part is greater than a maximum height of the first main body part, the second compensation part has a second protruding profile protruding from a top of the second main body part in a direction away from the base substrate, so that a maximum height of the second compensation part is greater than a maximum height of the second main body part, therefore, the first compensation part and the second compensation part can play a certain role of blocking light during the exposure process, to alleviate or even eliminate the adverse effects of the exposure diffraction effect on the first pixel definition part and the second pixel definition part, thus the first pixel definition part and the second pixel definition part next to the first isolation opening are prevented from being excessively thinned, and thus defects such as dark spots caused by the first pixel definition part and the second pixel definition part failing to completely cover the edge of the first electrode can be avoided, so that a slope angle of the edge profile of the first pixel definition part close to the first pixel opening is kept relatively consistent with a slope angle of the edge profile of the second pixel definition part close to the second pixel opening and slopes of edges of other pixel openings, thus color shift is avoided.

As illustrated by Fig. 12, because the first pixel definition part 130A is provided with the first compensation part 1302, the second pixel definition part 130B is provided with a second compensation part 1304, a width of the second pixel definition part 130B may be reduced, thus arrangement density of the pixel openings is increased.

In some examples, as illustrated by Fig. 12, a size of the second pixel definition part 130B in the first direction is equal to a size of the first pixel definition part 130A in the first direction. The first direction mentioned above is a direction from the first pixel opening 131 to the first isolation opening 132, and the first direction is parallel to the base substrate 110. In this way, structures of the first pixel definition part and the second pixel definition part are more symmetrical, thus a difference between a slope angle of the edge profile of the first pixel definition part close to the first pixel opening and a slope angle of the edge profile of the second pixel definition part close to the second pixel opening can be better reduced.

In some examples, as illustrated by Fig. 11, orthographic projections of the first isolation opening 132 and the second isolation opening 135 on the base substrate 110 may be in the shape of a strip. Of course, the embodiments of the present disclosure include but are not limited thereto.

For example, as illustrated by Fig. 11, a shape of the orthographic projection of the first isolation opening 132 on the base substrate 110 has a curved part at a position corresponding to the corner part of the first pixel opening 131, and a shape of the orthographic projection of the second isolation opening 135 on the base substrate 110 has a curved part at a position corresponding to the corner part of the first pixel opening 131.

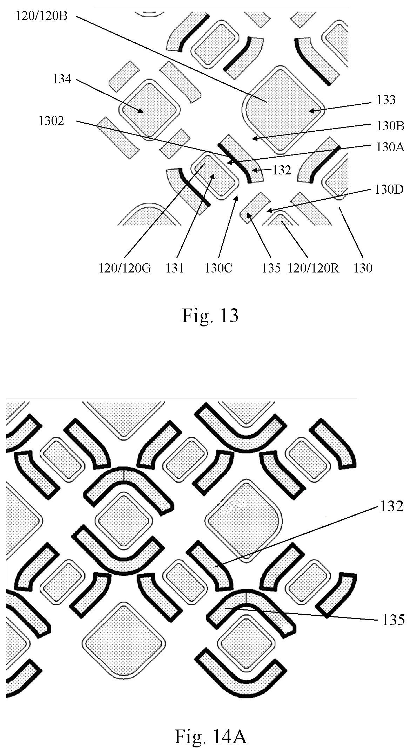

Fig. 13 is a planar schematic diagram of another display substrate provided by an embodiment of the present disclosure. As illustrated by Fig. 13, the pixel definition layer 130 includes a first pixel opening 131, a first isolation opening 132, a second pixel opening 133, a third pixel opening 134 and a second isolation opening 135; the first pixel definition part 130A located between the first pixel opening 131 and the first isolation opening 132 is provided with the first compensation part 1302, while the second pixel definition part 130B located between the first isolation opening 132 and the second pixel opening 133, and the third pixel definition part 130C located between the first pixel opening 131 and the second isolation opening 135, and the fourth pixel definition part 130D located between the third pixel opening 134 and the second isolation opening 135 are not provided with a compensation part.

Fig. 14A to Fig. 14C are planar schematic diagrams of other display substrates provided by an embodiment of the present disclosure. As illustrated by Fig. 14A to Fig. 14C, an orthographic projection of the first isolation opening 132 on the base substrate 110 may be in the shape of a strip, and an orthographic projection of the second isolation opening 135 on the base substrate 110 may be in an L-shape. Of course, the embodiments of the present disclosure include but are not limited thereto.

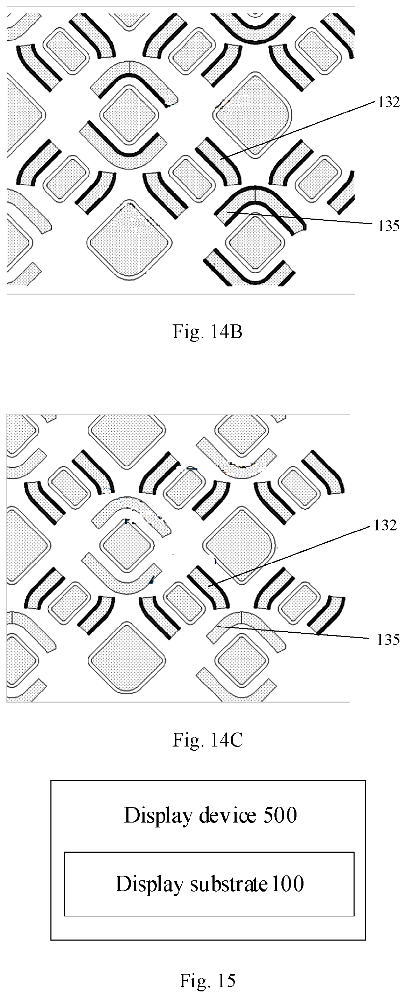

In some examples, as illustrated by Fig. 14A, peripheries of the first isolation opening 132 and the second isolation opening 135 may be designed with compensation rings, for details, please refer to the relevant descriptions of the embodiment shown in Fig. 8, which will not be repeated herein. As illustrated by Fig. 14B, peripheries of the first isolation opening 132 and the second isolation opening 135 may adopt a single-side compensation design or a double-side compensation design, for details, please refer to the relevant descriptions of the embodiment shown in Fig. 5, which will not be repeated herein. As illustrated by Fig. 14C, the periphery of the first isolation opening 132 may adopt a double-sided compensation design, while the periphery of the second isolation opening 135 does not adopt a compensation design. Therefore, the display substrate provided by the embodiment of the present disclosure can select which of the above compensation designs to adopt according to actual needs or a position of the defective light emitting element of the product.

An embodiment of the present disclosure further provides a display device. Fig. 15 is a schematic diagram of a display device provided by an embodiment of the present disclosure. As illustrated by Fig. 15, the display device 500 includes any one of the display substrates 100 mentioned above. In this way, the display device can prevent the first pixel definition part next to the first isolation opening from being excessively thinned, thus defects such as dark spots caused by the first pixel definition part failing to completely cover an edge of the first electrode can be avoided, so that a slope angle of the edge profile of the first pixel definition part close to the first pixel opening is kept relatively consistent with slopes of edges of other pixel openings, thus color shift is avoided.

In addition, the display device can also realize a double-layer light emitting (Tandem EL) design, so the display device has the advantages of long life, low power consumption, and high brightness. Furthermore, the display device can also avoid crosstalk between adjacent light emitting elements.

For example, the display device may be a display device such as an organic light emitting diode display device, and any product or component with a display function such as a television, a digital camera, a mobile phone, a watch, a tablet computer, a notebook computer and a navigator that include the display device, and the embodiment is not limited thereto.

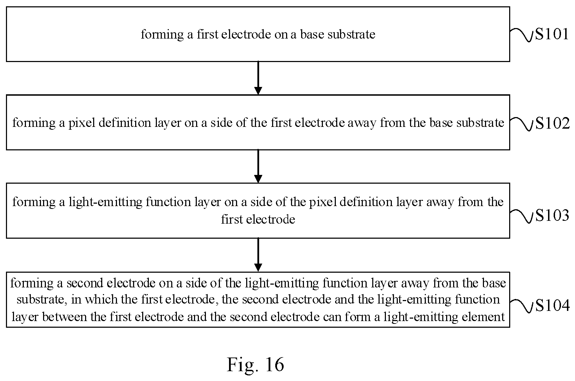

An embodiment of the present disclosure further provides a manufacturing method of a display substrate. Fig. 16 is a flow chart of a manufacturing method of a display substrate provided by an embodiment of the present disclosure. As illustrated by Fig. 16, the manufacturing method of the display substrate includes the following steps S101 to S104.

Step S101: forming a first electrode on a base substrate.

For example, forming a conductive material layer for forming the first electrode on the base substrate, and then forming the first electrode through a patterning process.

For example, the material of the base substrate can be made of one or more materials selected from the group consisting of glass, polyimide, polycarbonate, polyacrylate, polyetherimide, and polyethersulfone, the embodiment includes but is not limited thereto.

For example, the first electrode may be made of a metal material, such as any one or more of magnesium (Mg), silver (Ag), copper (Cu), aluminum (Al), titanium (Ti) and molybdenum (Mo), or alloy materials of the above metals, such as aluminum-neodymium alloy (AlNd) or molybdenum-niobium alloy (MoNb), can be a single-layer structure or a multi-layer composite structure, such as Ti/Al/Ti, can be a stack structure formed by metal and transparent conductive materials, such as ITO/Ag/ITO, Mo/AlNd/ITO and other reflective materials.

Step S102: forming a pixel definition layer on a side of the first electrode away from the base substrate.

For example, forming a material layer for forming a pixel definition layer on a side of the first electrode away from the base substrate by a coating process; then patterning the material layer through a patterning process to form the pixel definition layer.

For example, the material of the pixel definition layer may be a photosensitive material, such as a photosensitive resin. In this way, the pixel definition layer can be patterned only through an exposure process.

Step S103: forming a light emitting function layer on a side of the pixel definition layer away from the first electrode.

Step S104: forming a second electrode on a side of the light emitting function layer away from the base substrate, in which the first electrode, the second electrode and the light emitting function layer between the first electrode and the second electrode can form a light emitting element.

In the manufacturing method of the display substrate, the display substrate includes a plurality of light emitting elements, each of the plurality of light emitting element includes a first electrode, a light emitting function layer, and a second electrode, and the plurality of light emitting elements include first light emitting elements; the pixel definition layer includes a first pixel opening and a first isolation opening, the first pixel opening is located at a side of a first electrode of one of the first light emitting elements away from the base substrate, and exposes at least a part of the first electrode, the first isolation opening is located at a periphery of the first pixel opening, the pixel definition layer includes a first pixel definition part located between the first pixel opening and the first isolation opening and a second pixel definition part located on a side of the first isolation opening away from the first pixel opening, the first pixel definition part includes a first main body part and a first compensation part that are connected with each other, the first compensation part is located on a side of the first main body part close to the first isolation opening, the first compensation part has a first protruding profile protruding from the top of the first main body part toward a direction away from the base substrate, so that the maximum height of the first compensation part is greater than the maximum height of the first main body part.

In the manufacturing method of a display substrate provided by an embodiment of the present disclosure, in the step of forming a pixel definition layer on a side of the first electrode away from the base substrate, because the first pixel definition part includes a first compensation part, and the first compensation part has a first protruding profile protruding from the top of the first main body part toward a direction away from the base substrate, so that the maximum height of the first compensation part is greater than the maximum height of the first main body part, the first compensation part can play a certain role of blocking light during the exposure process, to alleviate or even eliminate the adverse effects of the exposure diffraction effect on the first pixel definition part, thus the first pixel definition part next to the first isolation opening is prevented from being excessively thinned, and thus defects such as dark spots caused by the first pixel definition part failing to completely cover an edge of the first electrode can be avoided, so that a slope angle of the edge profile of the first pixel definition part close to the first pixel opening is relatively consistent with a slope angle of the edge of other pixel openings, thus color shift is avoided.

For example, the light emitting function layer may include a plurality of sub-function layers; for example, the light emitting function layer includes a first light emitting layer, a second light emitting layer, and a charge generation layer located between the first light emitting layer and the second light emitting layer. The charge generation layer has strong conductivity, which can make the light emitting function layer have the advantages of long life, low power consumption and high brightness. For example, compared with a light emitting function layer without a charge generation layer, the first light emitting element can increase the light emitting brightness by nearly double by arranging a charge generation layer in the light emitting function layer. At the same time, because the pixel definition layer is arranged with a first isolation opening, and a pixel isolation structure is arranged below the first isolation opening, the charge generation layer is disconnected at a position where the pixel isolation structure is located in the first isolation opening. In this way, the manufacturing method of the display substrate can prevent the charge generation layer with higher conductivity in the light emitting function layer from causing crosstalk between adjacent light emitting elements.

In some examples, forming a pixel definition layer on a side of the first electrode away from the base substrate includes: forming a pixel definition material layer on a side of the first electrode away from the base substrate; and patterning the pixel definition material layer using a halftone mask, to form a first pixel opening, a first isolation opening, a first pixel definition part, and a second pixel definition part, in which the first main body part of the first pixel definition part corresponds to a partially light-transmitting part of the half-tone mask, and the first compensation part corresponds to a completely blocking part of the half-tone mask. Of course, the embodiments of the present disclosure include but are not limited thereto, the pixel definition layer may also be formed by using two masks and performing two exposure processes.

In some examples, the manufacturing method of the display substrate further includes: before forming the first electrode on the base substrate, forming an isolation function layer on the base substrate; the isolation function layer includes a first isolation groove, which is configured to at least isolate the charge generation layer in the light emitting function layer; and an orthographic projection of the first isolation opening on the base substrate covers an edge of the first isolation groove close to the first pixel opening. In this way, the first isolation opening can expose the first isolation groove to prevent the first isolation groove from being covered by the pixel definition layer, on the other hand, the first isolation opening can also increase the step difference, so that the charge generation layer in the light emitting function layer is better isolated.

In some examples, the isolation function layer may be a newly added film layer or a flat layer in the display substrate.

For example, the material of the isolation function layer may be an organic material or an inorganic material; the organic material may include one or a combination of resin, acrylic or polyethylene terephthalate, polyimide, polyamide, polycarbonate, and epoxy resin, and the inorganic material may include silicon oxide, silicon nitride and silicon oxynitride.

In some examples, before forming the isolation function layer on the base substrate, the manufacturing method of the display substrate further includes forming a pixel driving circuit on the base substrate; each of the plurality of pixel driving circuits may include a plurality of transistors and at least one storage capacitor, for example, the pixel circuit can adopt 2T1C, 3T1C or 7T1C design.

For example, the step of forming the pixel driving circuit may include sequentially depositing a first insulating film and an active layer film on the base substrate, and patterning the active layer film through a patterning process, to form a first insulating layer covering the entire base substrate and an active layer pattern arranged on the first insulating layer, in which the active layer pattern at least includes an active layer.

For example, the step of forming a pixel driving circuit may further include: depositing a second insulating film and a first metal film in sequence on a side of the active layer away from the base substrate, and patterning the first metal film through a patterning process, to form a second insulating layer covering the active layer pattern, and a first gate metal layer pattern arranged on the second insulating layer, in which the first gate metal layer pattern at least includes a gate electrode and a first capacitor electrode.

For example, the step of forming a pixel driving circuit may further include: depositing a third insulating film and a second metal film in sequence on a side of the first gate metal pattern away from the base substrate, and patterning the second metal film through a patterning process, to form a third insulating layer covering the first gate metal layer, and a second gate metal layer pattern arranged on the third insulating layer, in which the second gate metal layer pattern at least includes a second capacitor electrode, a position of the second capacitor electrode corresponds to a position of the first capacitor electrode.

For example, the step of forming a pixel driving circuit may further include: depositing a fourth insulating film, and patterning the fourth insulating film through a patterning process, to form a fourth insulating layer covering the second gate metal layer, in which at least two first via holes are formed in the fourth insulating layer, and the fourth insulating layer, the third insulating layer and the second insulating layer in the two first via holes are etched away, to expose a surface of the active layer of the active layer pattern.

For example, the step of forming a pixel driving circuit may further include: depositing a third metal film, and patterning the third metal film through a patterning process, to form a source-drain metal layer pattern on the fourth insulating layer, in which the source-drain metal layer pattern at least includes a source electrode and a drain electrode located in the display region. The source electrode and the drain electrode may be connected with the active layer in the active layer pattern through the first via holes, respectively.

For example, the first insulating layer, the second insulating layer, the third insulating layer and the fourth insulating layer may be made of any one or more of silicon oxide (SiOx), silicon nitride (SiNx) and silicon oxynitride (SiON), and may be a single layer, a multi-layer or a composite layer. The first insulating layer may be a buffer layer, which is used to improve the water and oxygen resistance of the base substrate; the second insulating layer and the third insulating layer may be gate insulating (GI) layers; the fourth insulating layer may be an interlayer dielectric (ILD) layer. The first metal film, the second metal film and the third metal film are made of metal materials, such as any one or more of silver (Ag), copper (Cu), aluminum (Al), titanium (Ti) and molybdenum (Mo), or alloy materials of the above metals, such as aluminum-neodymium alloy (AlNd) or molybdenum-niobium alloy (MoNb), and can be a single-layer structure or a multi-layer composite structure, such as Ti/Al/Ti. The active layer thin film is made of one or more materials such as amorphous indium gallium zinc oxide (a-IGZO), zinc oxynitride (ZnON), indium zinc tin oxide (IZTO), amorphous silicon (a-Si), polycrystalline silicon (p-Si), sexithiophene and polythiophene, that is, the present disclosure is applicable to transistors manufactured based on oxide technology, silicon technology, and organic technology.

The following statements should be noted:
(1) The accompanying drawings involve only the structure(s) in connection with the embodiment(s) of the present disclosure, and other structure(s) can be referred to common design(s).
(2) In case of no conflict, the embodiments of the present disclosure and the features in the embodiments can be combined with each other to obtain new embodiments.

What have been described above are only exemplary embodiments of the present disclosure and are not intended to limit the scope of protection of the present disclosure, and the scope of protection of the present disclosure is determined by the appended claims.

## Claims

1. A display substrate, comprising:
a base substrate;
a plurality of light emitting elements, located on the base substrate; and
a pixel definition layer,
wherein each of the plurality of light emitting elements comprises a first electrode, a light emitting function layer and a second electrode, the plurality of light emitting elements comprise a first light emitting element,
the pixel definition layer comprises a first pixel opening and a first isolation opening, the first pixel opening is located at a side of the first electrode of the first light emitting element away from the base substrate, and exposes at least a part of the first electrode, the first isolation opening is located at a periphery of the first pixel opening,
the pixel definition layer comprises a first pixel definition part located between the first pixel opening and the first isolation opening, and a second pixel definition part located on a side of the first isolation opening away from the first pixel opening,
the first pixel definition part comprises a first main body part and a first compensation part that are connected with each other, the first compensation part is located on a side of the first main body part close to the first isolation opening, the first compensation part has a first protruding profile protruding from a top of the first main body part toward a direction away from the base substrate, to make that a maximum height of the first compensation part is greater than a maximum height of the first main body part.

2. The display substrate according to claim 1, wherein one end of the first protruding profile is located at the top of the first main body part, other end of the first protruding profile is located at an edge of the first isolation opening.

3. The display substrate according to claim 1, wherein the first protruding profile intersects with an upper surface of the first main body part away from the base substrate at an inflection point, an angle between a tangent line passing through the inflection point and tangent to the first protruding profile and a tangent line passing through the inflection point and tangent to the upper surface is less than 180 degrees.

4. The display substrate according to any one of claims 1 to 3, wherein an edge profile of the first pixel definition part close to the first isolation opening has a first slope angle, an edge profile of the second pixel definition part close to the first isolation opening has a second slope angle, and a difference between the first slope angle and the second slope angle ranges from 0 to 40 degrees.

5. The display substrate according to claim 4, wherein the first slope angle is greater than the second slope angle, and the difference between the first slope angle and the second slope angle ranges from 20 to 40 degrees.

6. The display substrate according to claim 5, wherein an edge profile of the first pixel definition part close to the first pixel opening has a third slope angle, and a difference between the third slope angle and the first slope angle ranges from 20 to 40 degrees.

7. The display substrate according to any one of claims 1 to 6, wherein a difference between the third slope angle and the second slope angle is less than 5 degrees.

8. The display substrate according to any one of claims 1 to 7, wherein a maximum height of the first main body part is the same as a maximum height of the second pixel definition part, and a maximum height of the first compensation part is greater than the maximum height of the first main body part.

9. The display substrate according to any one of claims 1 to 7, wherein the first protruding profile has a fourth slope angle on a side close to the first main body part, and the fourth slope angle has a value range of 0 to 20 degrees.

10. The display substrate according to any one of claims 1 to 7, wherein a direction from the first pixel opening to the first isolation opening is a first direction, a ratio of a width of the first compensation part in the first direction to a width of the first main body part in the first direction is in a range of 0 to 0.3.

11. The display substrate according to any one of claims 1 to 10, further comprising:
an isolation function layer, located between the base substrate and the plurality of light emitting elements in a direction perpendicular to the base substrate,
wherein the isolation function layer comprises a first isolation groove, an orthographic projection of the first isolation opening on the base substrate covers an edge of the first isolation groove close to the first pixel opening.

12. The display substrate according to claim 11, wherein the light emitting function layer comprises a charge generation layer, and the charge generation layer is disconnected at an edge of the first isolation groove close to the first pixel opening.

13. The display substrate according to claim 12, wherein the light emitting function layer further comprises a first light emitting layer and a second light emitting layer located on two sides of the charge generation layer in a direction perpendicular to the base substrate respectively.

14. The display substrate according to any one of claims 1 to 13, wherein the plurality of light emitting elements comprise a second light emitting element, the pixel definition layer further comprises a second pixel opening, located on a side of the first electrode of the second light emitting element away from the base substrate, and exposing at least a part of the first electrode,
the second pixel opening is located on a side of the first isolation opening away from the first pixel opening, and the second pixel definition part is located between the first isolation opening and the second pixel opening.

15. The display substrate according to claim 14, wherein a size of the second pixel definition part in a first direction is greater than a size of the first pixel definition part in the first direction.

16. The display substrate according to claim 14, wherein the second pixel definition part comprises a second main body part and a second compensation part that are connected with each other, the second compensation part is located on a side of the second main body part close to the first isolation opening,
the second compensation part has a second protruding profile that protrudes from a top of the second main body part toward a direction away from the base substrate, to make that a maximum height of the second compensation part is greater than a maximum height of the second main body part.

17. The display substrate according to claim 16, wherein the first compensation part and the second compensation part are connected at two opposite edges of the first isolation opening in a second direction, to surround the first isolation opening, the second direction is perpendicular to a direction from the first pixel opening to the first isolation opening.

18. The display substrate according to claim 16, wherein a size of the second pixel definition part in a first direction is equal to a size of the first pixel definition part in the first direction.

19. The display substrate according to any one of claims 14 to 18, wherein the plurality of light emitting elements comprise a third light emitting element, the pixel definition layer further comprises a third pixel opening and a second isolation opening,
the third pixel opening is located at a side of the first electrode of the third light emitting element away from the base substrate and exposes at least a part of the first electrode, and the second isolation opening is located between the first pixel opening and the third pixel opening,
the pixel definition layer comprises a third pixel definition part located between the first pixel opening and the second isolation opening and a fourth pixel definition part located between the second isolation opening and the third pixel opening, and
the third pixel definition part comprises a third main body part and a third compensation part that are connected to each other, the third compensation part is located on a side of the third main body part close to the second isolation opening, the third compensation part has a third protruding profile protruding from a top of the third main body part toward a direction away from the base substrate, to make that a maximum height of the third compensation part is greater than a maximum height of the third main body part.

20. The display substrate according to claim 19, further comprising:
an isolation function layer, located between the base substrate and the plurality of light emitting elements in a direction perpendicular to the base substrate,
wherein the isolation function layer comprises a second isolation groove, and an orthographic projection of the second isolation opening on the base substrate covers an edge of the second isolation groove close to the first pixel opening.

21. The display substrate according to any one of claims 1 to 20, wherein a shape of an orthographic projection of the first isolation opening on the base substrate comprises at least one of a strip shape and an L shape.

22. The display substrate according to any one of claims 1 to 20, wherein the first compensation part is reused as a spacer.

23. The display substrate according to claim 22, wherein a maximum height of the spacer in a direction perpendicular to the base substrate is in a range of 0.9 microns to 1.3 microns.

24. The display substrate according to claim 22, wherein a difference between a maximum height of the spacer and the maximum height of the first main body part is in a range of 0.1 microns to 0.5 microns.

25. A display substrate, comprising:
a base substrate;
a plurality of light emitting elements, located on the base substrate; and
a pixel definition layer,
wherein each of the plurality of light emitting elements comprises a first electrode, a light emitting function layer and a second electrode, the plurality of light emitting elements comprise a first light emitting element,
the pixel definition layer comprises a first pixel opening and a first isolation opening, the first pixel opening is located at a side of a first electrode of the first light emitting element away from the base substrate and exposes at least a part of the first electrode, and the first isolation opening is located at a periphery of the first pixel opening,
the pixel definition layer comprises a first pixel definition part located between the first pixel opening and the first isolation opening, and a second pixel definition part located on a side of the first isolation opening away from the first pixel opening, and
an edge profile of the first pixel definition part close to the first isolation opening has a first slope angle, an edge profile of the second pixel definition part close to the first isolation opening has a second slope angle, and the first slope angle and the second slope angle are different from each other.

26. The display substrate according to claim 25, wherein the first slope angle is greater than the second slope angle.

27. A display device, comprising the display substrate according to any one of claims 1 to 26.

28. A manufacturing method of a display substrate, comprising:
forming a first electrode on a base substrate;
forming a pixel definition layer on a side of the first electrode away from the base substrate;
forming a light emitting function layer on a side of the pixel definition layer away from the first electrode; and
forming a second electrode on a side of the light emitting function layer away from the base substrate,
wherein the display substrate comprises a plurality of light emitting elements, each of the plurality of the light emitting elements comprises the first electrode, the light emitting function layer and the second electrode, the plurality of light emitting elements comprise a first light emitting element,
the pixel definition layer comprises a first pixel opening and a first isolation opening, the first pixel opening is located at a side of the first electrode of the first light emitting element away from the base substrate and exposes at least a part of the first electrode, and the first isolation opening is located at a periphery of the first pixel opening,
the pixel definition layer comprises a first pixel definition part located between the first pixel opening and the first isolation opening, and a second pixel definition part located on a side of the first isolation opening away from the first pixel opening,
the first pixel definition part comprises a first main body part and a first compensation part that are connected with each other, the first compensation part is located on a side of the first main body part close to the first isolation opening, the first compensation part has a first protruding profile that protrudes from a top of the first main body part toward a direction away from the base substrate, to make that a maximum height of the first compensation part is greater than the maximum height of the first main body part.

29. The manufacturing method of a display substrate according to claim 28, wherein forming a pixel definition layer on a side of the first electrode away from the base substrate comprises:
forming a pixel definition material layer on a side of the first electrode away from the base substrate; and
patterning a pixel definition material layer by using a half-tone mask to form the first pixel opening, the first isolation opening, the first pixel definition part and the second pixel definition part,
wherein a first main body part of the first pixel definition part corresponds to a part of a transparent part of the half-tone mask, and the first compensation part corresponds to a completely blocking part of the half-tone mask.
